# EUROPEAN PATENT APPLICATION

(11) **EP 2 744 310 A1**
(43) Date of publication of application: **18.06.2014**
(21) Application number: 12821958.1
(22) Date of filing: 02.07.2012
(51) Int. Cl.: H05K 1/09, H01L 23/12

(54) **WIRING SUBSTRATE AND METHOD FOR MANUFACTURING SAME AND SEMICONDUCTOR DEVICE**

(30) Priority: 11.08.2011 JP 2011176352
(71) Applicant: Furukawa Electric Co., Ltd., Chiyoda-ku Tokyo 100-8322 (JP)
(72) Inventor: WATANABE, Masato, Tokyo 100-8322 (JP); HIKASA, Kazuhito, Tokyo 100-8322 (JP)
(74) Representative: Horn Kleimann Waitzhofer
(86) International application number: PCT/JP2012/066870
(87) International publication number: WO 2013/021750

(57) **Abstract**

To provide a wiring substrate that has favorable adhesion with a sealing resin and high reliability in addition to high heat dissipation, without increasing the thickness of layers disposed on the substrate, and to provide a manufacturing method thereof as well as a semiconductor device that mounts semiconductor elements on this wiring substrate. A wiring substrate according to the present invention includes a substrate having an insulating layer, and wiring provided on one surface side of the substrate. The wiring includes a porous conductive layer having a plurality of vacancies inside, and the wiring has different surface areas for the surface of the substrate side and for the surface opposite the surface of the substrate side.

## Description

### BACKGROUND

### Technical Field

The present invention relates to a wiring substrate and a manufacturing method thereof and to a semiconductor device, and particularly relates to a technique distinguished by the structure of the wiring substrate.

### Related Art

Semiconductor elements that supply and/or control power (so-called power semiconductor elements) generate a large amount of heat during operation, and therefore, direct bonded copper (DBC) substrates are widely used in which a copper circuit board is directly bonded onto a ceramic circuit board when mounting (for example, Japanese Unexamined Patent Application Publication No. 2003-188316). It is common for materials having insulating properties and high thermal conductivity such as Al₂O₃ or AlN to be used in ceramics with a structure that conducts the heat generated from the semiconductor elements to a heat sink or other heat dissipation device arranged on the ceramic substrate back surface.

However, DBC substrates are problematic in that there is a long process time and power consumption increases during the process, because it is necessary to heat the copper circuit board for a long time at 1000°C or higher, near the melting point of copper, when joining to the ceramic substrate.

Further, there are problems with semiconductor devices that mount semiconductor elements on the DBC substrate described above, namely that the semiconductor device undergoes stress when exposed to high temperatures during and after the manufacturing process, and delamination and cracking may occur. This is because differences in coefficients of linear expansion in the semiconductor elements and the copper circuits and differences in coefficients of linear expansion in the ceramic substrate and the copper circuits are large.

Furthermore, because the DBC substrate is heated to 1000°C or higher when joining the copper circuit board to the ceramic substrate, the copper circuits maintain residual tensile stress. Therefore, delamination and cracking more easily occur in a semiconductor device.

A wiring substrate that resolves these problems is known (see Japanese Unexamined Patent Application Publication No. 2006-228804) wherein the wiring substrate has a layer that contains metallic nanoparticles interposed between the ceramic substrate and the metal plate that becomes the conductor pattern and then joining is performed by heating.

However, in the wiring substrate disclosed in Japanese Unexamined Patent Application Publication No. 2006-228804, there is a problem in that the heat dissipation effect is insufficient. Further, when sealing after the semiconductor elements are mounted onto the wiring substrate, adhesion with the sealing resin is insufficient. Therefore, the sealing resin easily peels away from the wiring, a problem occurs of further lowering of the heat dissipation efficiency in the sealing resin, and reliability of the wiring substrate is insufficient.

Here, in order to increase the heat dissipation effect and the adhesion with the sealing resin, increasing the thickness of the layers disposed on the substrate has been considered. However, because there is a long distance from the semiconductor elements, which are the source of the heat, to the heat dissipation device on the substrate back surface, there is the potential for increasing the thermal resistance of the wiring substrate.

Therefore, an object of the present invention is to provide a wiring substrate that has favorable adhesion with the sealing resin and high reliability in addition to a high heat dissipation effect, without increasing the thickness of the layers disposed on the substrate, and to provide a manufacturing method thereof as well as a semiconductor device that mounts semiconductor elements on this wiring substrate.

### SUMMARY

In order to achieve an object such as that described above, the wiring substrate according to the present invention includes a substrate having an insulating layer, and wiring provided on one surface side of the substrate. The wiring includes a porous conductive layer having a plurality of vacancies inside, and the wiring has different surface areas for the surface of the substrate side and for the surface opposite the surface of the substrate side.

Further, the wiring substrate according to the present invention includes a substrate having an insulating layer, and wiring provided on one surface side of the substrate. The wiring includes a porous conductive layer having a plurality of vacancies inside, and has an additional layer with a higher modulus of elasticity than the porous conductive layer between the wiring and the substrate. Additionally, surface areas are different for the surface of the substrate side of the additional layer and for the surface opposite the surface of the substrate side of the wiring.

Further, the wiring substrate according to the present invention includes a substrate having an insulating layer, and wiring including a plurality of layers provided on one surface side of the substrate. Any one layer of the wiring includes a porous conductive layer having a plurality of vacancies inside. Additionally, the wiring has different surface areas for the surface of the substrate side and for the surface opposite the surface of the substrate side.

Further, the wiring substrate according to the present invention includes a substrate having an insulating layer, and wiring including a plurality of layers provided on one surface side of the substrate. Any one layer of the wiring includes a porous conductive layer having a plurality of vacancies inside, and has an additional layer with a higher modulus of elasticity than the porous conductive layer between the wiring and the substrate. Additionally, surface areas are different for the surface of the substrate side of the additional layer and for the surface opposite the surface of the substrate side of the wiring.

Further, the wiring substrate according to the above invention preferably is such that surface areas are different for a surface of the substrate side and for a surface opposite the surface of the substrate side in all layers provided on the wiring side on the substrate. Additionally, z/x is preferably less than or equal to 10, when z is defined as a total thickness of all layers provided on the wiring side on the substrate and x is defined as a protruding length in one direction of any one surface relative to the other surface of a surface of the substrate side and a surface opposite the surface of the substrate side.

Further, the wiring substrate according to the above invention preferably includes a metal thin film, provided on the other surface side of the substrate.

Further, in the wiring substrate according to the above invention, the metal thin film preferably includes a porous conductive layer having a plurality of vacancies inside.

Further, in the wiring substrate according to the above invention, the metal thin film preferably includes a plurality of layers and any one layer includes a porous conductive layer having a plurality of vacancies inside.

Further, in the wiring substrate according to the above invention, the wiring and the metal thin film preferably include three layers, and each layer other than an intermediate layer includes a porous conductive layer having a plurality of vacancies inside.

Further, the wiring substrate according to the above invention preferably includes an additional layer having a higher modulus of elasticity than the porous conductive layer of the metal thin film, provided between the metal thin film and the substrate.

Further, the wiring substrate according to the above invention preferably is such that surface areas are different for a surface of the substrate side and for a surface opposite the surface of the substrate side in all layers provided on the metal thin film side on the substrate. Additionally, z/x preferably is less than or equal to 10, when z is defined as a total thickness of all layers provided on the wiring side on the substrate and x is defined as a protruding length in one direction of any one surface relative to the other surface of a surface of the substrate side and a surface opposite the surface of the substrate side.

Further, in the wiring substrate according to the above invention, a thickness of the additional layer preferably is not more than 10 µm.

Further, in the wiring substrate according to the above invention, a coefficient of linear expansion of the additional layer preferably is not less than a coefficient of linear expansion of the insulating layer and is not greater than a coefficient of linear expansion of the wiring.

Further, in the wiring substrate according to the above invention, the substrate preferably has a foundation layer for adhering with other members.

Further, the wiring substrate according to the above invention preferably includes an adhesive layer for adhering with other members, provided on one or both surfaces of a layer other than the porous conductive layer of the wiring.

Further, the wiring substrate according to the above invention preferably includes an adhesive layer for adhering with other members, provided on one or both surfaces of a layer other than the porous conductive layer of the metal thin film.

Further, the wiring substrate according to the above invention preferably includes a processing layer processed to cause atomic vacancy and/or dislocation, formed on a top surface of at least any one layer provided on the insulating layer.

Further, in the wiring substrate according to the above invention, a layer other than the porous conductive layer of the wiring preferably includes one type of metal, an alloy of two or more types of metals, or an alloy where a main component is made up of one or more types of metals, selected from a metal element group including Cu, Al, Au, and Ag.

Further, in the wiring substrate according to the above invention, a layer other than the porous conductive layer of the metal thin film preferably includes one type of metal, an alloy of two or more types of metals, or an alloy where a main component is made up of one or more types of metals, selected from a metal element group including Cu, Al, Au, and Ag.

Further, in the wiring substrate according to the above invention, a layer other than a porous conductive layer of the wiring is preferably softened by being annealed.

Further, in the wiring substrate according to the above invention, a layer other than a porous conductive layer of the wiring is preferably softened by being annealed.

Further, in the wiring substrate according to the above invention, the foundation layer preferably includes a metal material, an organic material, or a blended material of a metal material and an organic material.

Further, in the wiring substrate according to the above invention, the insulating layer preferably includes an organic material or ceramics.

Further, in the wiring substrate according to the above invention, the insulating layer preferably includes any one or plurality of Al₂O₃, AlN, Si₃N₄, and glass.

Further, in the wiring substrate according to the above invention, the porous conductive layer preferably is made of sintered metallic fine particles.

Further, in the wiring substrate according to the above invention, the vacancies preferably are filled with organic material at any ratio.

Further, in the wiring substrate according to the above invention, a volume percent for occupancy of a metal material within the porous conductive layer preferably is in a range between 50 and 99.999%.

Further, in the wiring substrate according to the above invention, the metallic fine particles preferably include particles having an average particle diameter of primary particles of 1 nm to 500 nm at a ratio of 50 wt% or more and particles having an average particle diameter of primary particles of 0.5 µm to 50 µm at a ratio of 50 wt% or less. Note that the average particle diameter of primary particles means the average diameter of primary particles that are individual metallic fine particles configuring secondary particles. These primary particle diameters can be measured using an electron microscope. Further, the average particle diameter means a number-average particle diameter of the primary particles.

Further, in the wiring substrate according to the above invention, the metallic fine particles preferably are components of mainly metal of any one type or two or more types from among Cu, Ag, Au, Al, Ni, Sn, In, and Ti.

Further, the insulating layer preferably is Al₂O₃ or AlN, and a ratio of a thickness of the insulating layer to a thickness of a layer other than the porous conductive layer of the wiring is 1.5 or less.

Further, the insulating layer preferably is Si₃N₄, and a ratio of a thickness of the insulating layer to a thickness of a layer other than the porous conductive layer of the wiring is 0.25 or less.

Further, a manufacturing method of a wiring substrate according to the present invention is a manufacturing method of a wiring substrate that manufactures a wiring substrate according to any one of the above, and includes a step for heating a material where a main component is metallic fine particles while applying pressure, and bonding mutually between metallic fine particles and bonding the metallic fine particles to other layers to form the porous conductive layer.

Further, a manufacturing method of a wiring substrate according to the present invention is a manufacturing method of a wiring substrate that manufactures a wiring substrate according to any one of the above, and includes a step for heating a material where a main component is metallic fine particles without applying pressure, and bonding mutually between metallic fine particles and bonding the metallic fine particles to other layers to form the porous conductive layer.

Further, the semiconductor device according to the present invention includes semiconductor elements mounted on a wiring substrate according to any one of the above.

Further, in the semiconductor device according the above invention, the semiconductor elements preferably are connected to the wiring substrate by an element connecting porous conductive layer having a plurality of vacancies inside.

The wiring substrate of the present invention increases the surface area of the side surface of the wiring substrate, to thereby improve heat dissipation of the wiring substrate and improve adhesion between the sealing resin and the wiring substrate, thus improving reliability of the wiring substrate.

Further, according to the wiring substrate of the present invention, the process time can be decreased and power consumption during the process can be reduced because there is no need for prolonged heating at a high temperature, such as when bonding the wiring composed solely of bulk material to the substrate, because the wiring includes the porous conductive layer having a plurality of vacancies inside. Furthermore, because there is a plurality of vacancies inside the wiring, stress from thermal expansion is absorbed by the vacancies and the apparent modulus of elasticity decreases, even if the metal configuring the wiring expands due to heat. Further, even if stress is caused by differences in the coefficients of linear expansion of the semiconductor element and the wiring and the substrate and the wiring, the stress is mitigated because it is absorbed by the vacancies. Therefore, the occurrence of delamination or cracking in the wiring substrate can be decreased when the semiconductor element is mounted.

### BRIEF DESCRIPTION OF THE DRAWINGS

FIG. 1 is a sectional view schematically illustrating a wiring substrate according to an embodiment.
FIG. 2 is a sectional view schematically illustrating a modified example of the wiring substrate according to the present embodiment.
FIG. 3 is an explanatory diagram for explaining the shape of the wiring and the additional layer of the wiring substrate according to the present embodiment.
FIG. 4 is a sectional view schematically illustrating another modified example of the wiring substrate according to the present embodiment.
FIG. 5 is a sectional view schematically illustrating another modified example of the wiring substrate according to the present embodiment.
FIG. 6 is an explanatory diagram that schematically explains a method for manufacturing a wiring substrate according to the present embodiment.
FIG. 7 is an explanatory diagram that schematically explains a method for manufacturing a wiring substrate according to the present embodiment.
FIG. 8 is a sectional view schematically illustrating a semiconductor device having a semiconductor element mounted on the wiring substrate according to the present embodiment.
FIG. 9 is a sectional view schematically illustrating another modified example of the wiring substrate according to the present embodiment.
FIG. 10 is a sectional view schematically illustrating another modified example of the wiring substrate according to the present embodiment.

### DETAILED DESCRIPTION OF THE INVENTION

An embodiment of the present invention will be described in detail hereinafter with reference to the drawings.

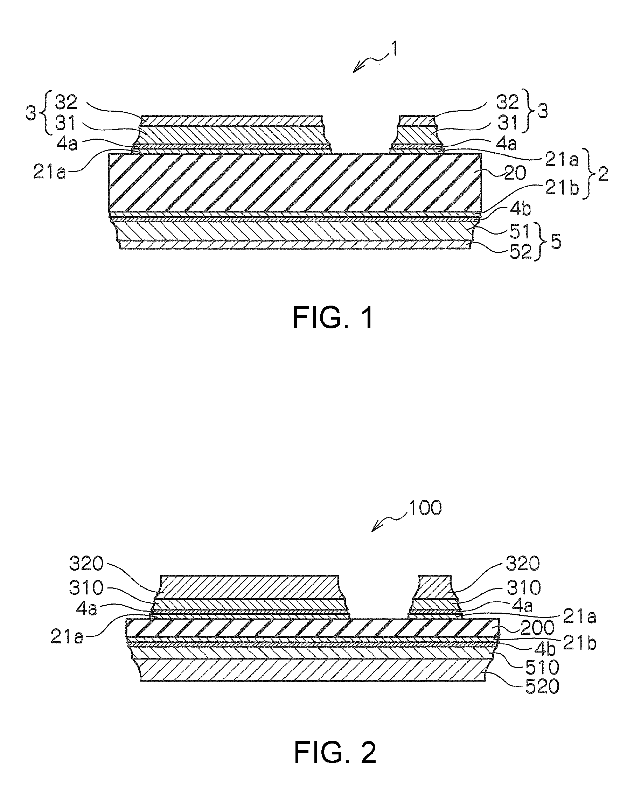

A wiring substrate 1 according to an embodiment, as illustrated in FIG. 1, has a substrate 2, having an insulating layer 20 and foundation layers 21a and 21b, and wiring 3 provided on one surface side of the substrate 2. The wiring 3 includes two layers of a first wiring 31 positioned on the substrate 2 side and a second wiring 32 provided on the first wiring 31, and the first wiring 31 is made up of a porous conductive layer having a plurality of vacancies inside. An additional layer 4a, having a higher modulus of elasticity than the first wiring 31 made up of a porous conductive layer, is provided between the foundation layer 21a of the substrate 2 and the wiring 3. Further, a metal thin film 5 is provided on the other surface side of the substrate 2. The metal thin film 5 includes two layers of a first metal thin film 51 positioned on the substrate 2 side and a second metal thin film 52 positioned on the first metal thin film 51, and the first metal thin film 51 is made up of a porous conductive layer having a plurality of vacancies inside. An additional layer 4b, having a higher modulus of elasticity than the first metal thin film 51 made up of a porous conductive layer, is provided between the foundation layer 21b of the substrate 2 and the metal thin film 5.

Components of the wiring substrate 1 according to the present embodiment will be described in detail below.

### (Substrate 2)

The substrate 2 includes an insulating layer 20, such as an organic material or a ceramic or the like, and foundation layers 21a and 21 b.

Examples of ceramics that can be used include ceramics produced by a powder raw material of any of Al₂O₃, AlN, Si₃N₄ or glass, by two or more of these powder raw materials, or by blending a binder component as needed with a powder raw material where a main component is made up of these, and forming into a sheet-shape and calcining. Further, the substrate 2 including ceramics may be smoothed by appropriately grinding, or the like, the top surface with an abrasive grain.

Examples of organic materials that can be used include materials such as polyamide, epoxy, polyimide, and the like, or photosensitive or displacement plated materials of these, generally. Note that materials that can be used are not limited to these, but that any material suited to the objective of the present invention can be used.

The thickness of the insulating layer 20 can be appropriately designed, but it is preferably between 100 and 1000 µm. Particularly, when providing a heat dissipation device on the surface of the metal thin film 5 side of the wiring substrate 1, the thickness of the insulating layer 20 can be thin, between 100 and 300 µm, thereby enabling a small thermal resistance from the semiconductor element mounted surface of the wiring substrate 1 to the heat dissipation device surface.

The foundation layers 21a and 21b are firmly connected to the substrate 2 and the additional layers 4a, and 4b, and are formed of a metal material, organic material, or a blended material of a metal material and an organic material. Ti, Cr, Cu, Ni, Ag, or Au can be suitably used as the metal material. Furthermore, examples of organic materials that can be suitably used include materials such as polyamide, epoxy, polyimide, and polyhydric alcohol, or photosensitive or displacement plated materials of these, generally. Further, examples of blended materials of a metal material and an organic material that can be suitably used include materials in which any of the above metal materials and organic materials are blended in any ratio.

The thickness of the foundation layer 21a can be appropriately designed, but it is preferably between 0.01 and 5 µm. The insulating layer 20, if not undergoing a smoothing process, will normally have unevenness on the top surface. Forming the additional layer 4a and the first wiring 31 and second wiring 32 while unevenness remains brings about signal attenuation and increased noise when passing high frequency signals through the manufactured wiring substrate 1. To prevent this, the uneven surface can be made smooth by thickly forming the foundation layer 21a between 1 and 5 µm as an alternative to a smoothing process. By doing this, the smoothing process of the insulating layer 20 can be omitted, thereby enabling lower a manufacturing cost for the wiring substrate 1. When the wiring substrate 1 is not intended for high frequency signal use, the foundation layer 21a can be thinly formed between 0.01 and 0.05 µm, thereby leaving unevenness of the insulating layer 20 also on the top surface of the foundation layer 21a, and the additional layer 4a can therefore be more firmly joined to the foundation layer 21a. The foundation layer 21b, from a perspective of preventing warping and the like, is preferably designed to be a thickness corresponding to the foundation layer 21a.

Note that a porous conductive layer having a plurality of vacancies inside may also be used as the foundation layers 21a and 21b similarly as the first wiring 31 and the first metal thin film 51. In this case, the foundation layers 21a and 21b may be produced by uniformly supplying a similar material as that of the first wiring 31 and the first metal thin film 51 for the insulating layer 20 and then forming the porous conductive layer by conducting calcining or plasma treatment in an inert or reduction atmosphere. Conducting a plasma treatment can shorten the formation time compared to normal heating.

### (First Wiring 31)

The first wiring 31 is made up of a porous conductive layer having a plurality of vacancies inside. The material configuring the porous conductive layer is not particularly limited as long as it is a metal material having conductivity, and materials having low electrical resistivity such as copper, silver, or aluminum, are preferred. The vacancy referred to here is a portion formed in the metal material where the metal material does not exist and may be filled with organic material in any ratio. More specifically, organic material may fill a single vacancy in any ratio, and this type of vacancy may exist in plurality in any ratio. At this time, there may be vacancies that are completely filled by the organic material, and there may be vacancies that are not filled at all. The size of the vacancies is preferably an average maximum width between 10 and 1000 nm. When the size of the vacancies is smaller than 10 nm, stress that occurs when the metal material configuring the porous conductive layer attempts to expand, or stress that occurs caused by different coefficients of linear expansion between the semiconductor element, wiring substrate 1, and the wiring 3, cannot be effectively absorbed. When the size is larger than 1000 nm, the electrical conductivity is reduced.

The porous conductive layer is preferably produced by sintering metallic fine particles. Further, the metallic fine particles are preferably components of mainly metal of any one type or two or more types from among Cu, Ag, Au, Al, Ni, Sn, In, and Ti. In addition to these metals, as components that can be suitably used, organic materials such as polyamide, epoxy, polyimide, and polyhydric alcohol, and photosensitive or displacement plated materials of these, generally, may be included. Further, a dispersing agent and/or thickening agent is preferably included in addition to the metallic fine particles for easy handling prior to sintering the metallic fine particles. Polyhydric alcohol and the like may be used as the dispersing agent. Moreover, polyvinylpyrrolidone and the like may be used as the thickening agent.

The metallic fine particles include particles having an average particle diameter of primary particles of 1 nm to 500 nm at a ratio of 50 wt% or more and particles having an average particle diameter of primary particles of 0.5 µm to 50 µm at a ratio of 50 wt% or less. When the porous conductive layer includes sintered fine particles, vacancies are formed by gaps between the metallic fine particles. Further, common examples of organic materials include polyamide, epoxy, polyimide, polyhydric alcohol, and the like, and photosensitive or displacement plated materials of these. The volume percent for occupancy of a metal material within the porous conductive layer is in a range between 50 and 99.999%.

The vacancies of the first wiring 31 may be obtained by processing the wiring formed out of the metal thin film or plating using etching, laser processing, and the like. Further, when the first wiring 31 is formed by plating and the like, there is a method for forming a conductor using a plating solution mixed with an organic material that precipitates at an arbitrary rate.

The thickness of the first wiring 31 can be appropriately designed, but is preferably between 5 and 300 µm. The second wiring 32 expands under a high temperature environment according to the linear expansion coefficient of the material. Because this expansion is greater than that compared to the substrate 2, the difference in the above linear expansions must be buffered by the first wiring 31 to prevent breakage between the second wiring 32 and the substrate 2. It is preferable that the first wiring 31 is thinly produced within a range that allows buffering between this linear expansion difference. Because the first wiring 31 is expensive compared to normal metal foil, using a smaller amount enables the cost of the wiring substrate 1 to be lowered.

### (Second Wiring 32)

The second wiring 32 preferably includes one type of metal, an alloy of two or more types of metals, or an alloy where a main component is made up of one or more types of metal selected from a metal element group including Cu, Al, Au, and Ag, and particularly preferably includes a material having low electrical resistivity such as a metal like Cu or Al.

Because the second wiring 32 substantially contains vacancies inside, it can compensate for the low electrical conductivity of the first wiring 31 made up of a porous conductive layer. Further, providing the second wiring 32 as the topmost layer of the wiring 3 allows the top surface of the wiring 3 to be smooth, thereby allowing high frequency characteristics to be improved. Moreover, smoothing the top surface of the wiring 3 allows secure connection by wire bonding.

Further, the second wiring 32 is preferably softened by being annealed. In this manner, thermal stress generated in a high temperature environment can be reduced. Moreover, cracks and the like that occur in the second wiring 32 due to stress applied from the outside onto the second wiring 32 can be prevented. Softening by being annealed refers to a state when crystal grains of the metallic material forming the second wiring 32 are relatively larger than normal so as to cancel dislocation that occurs due to work hardening. If a metal material having large crystal grains is used, circuits with little electrical resistance can be formed.

The thickness of the second wiring 32 can be appropriately designed, but is preferably between 100 and 1000 µm. However, as illustrated in FIG. 2, when the thickness of the insulating layer 200 is thinned to reduce the thermal resistance from the semiconductor element mounting surface of the wiring substrate 100 to the heat dissipation device surface, the thickness of the second wiring 320 must be thickened by the amount that the insulating layer 200 is thinned, in order to maintain the overall strength of the wiring substrate 100. At this time, a ratio of the thickness of the insulating layer 200 relative to the thickness of the second wiring 320 (thickness of the insulating layer 200 / thickness of the second wiring 320) is preferably 1.5 or less when using Al₂O₃ or AlN as the insulating layer 200, and a ratio of the thickness of the insulating layer 200 relative to the second wiring 320 (thickness of the insulating layer 200 / thickness of the second wiring 320) is 0.25 or less when using Si₃N₄ as the insulating layer 200. Further, because the first wiring 310 buffers the thermal expansion difference between the second wiring 320 and the insulating layer 200 as described above, the thickness of the first wiring 310 must be appropriately set in accordance with this. Further, the thicknesses of the first metal thin film 510 and the second metal thin film 520 must be appropriately set so that warping and the like does not occur in the wiring substrate 100 in conjunction with the changes in thickness to the first wiring 310 and the second wiring 320.

### (First Metal Thin Film 51)

The first metal thin film 51 is made up of a porous conductive layer having a plurality of vacancies inside and is made of a material similar to that of the first wiring 31. It is preferable that the size of the thermal stress on the top and bottom of the substrate 2 be identical in the wiring substrate 1, so as to effectively mitigate warping and cracking due to thermal stress that occurs with temperature change. Providing the first metal film enables the size of the thermal stress to be the same on both sides of the substrate 2.

### (Second Metal Thin Film 52)

The second metal thin film 52 is made of a material similar to that of the second wiring 32. Similar to the first metal film, providing the second metal film enables the size of the thermal stress to be the same on both sides of the substrate 2.

### (Additional Layer 4a and 4b)

The additional layers 4a and 4b have higher moduli of elasticity than the porous conductive layer. The moduli of elasticity of the additional layers 4a and 4b are preferably higher than that of the porous conductive layer by about 5 GPa to 150 GPa. The material used that configures the additional layers 4a and 4b is not particularly limited as long as the material has a higher modulus of elasticity than the porous conductive layer, and can be, for example, Cu, Mo, Cr, or an alloy thereof. From a perspective of adhesion and improvement of conductivity, use of Cu is preferred as it exhibits favorable properties as circuit material. Here, the modulus of elasticity of the porous conductive layer is the modified modulus of elasticity after changing the apparent modulus of elasticity through the presence of the vacancies.

Because the moduli of elasticity for the additional layers 4a and 4b are higher than the modulus of elasticity of the porous conductive layer, the thermal expansion of the wiring 3 does not transfer to the substrate 2, and cracking of the substrate 2 can therefore be suppressed. Further, because use of additional layers 4a and 4b having higher moduli of elasticity increases the rigidity of the wiring substrate, the substrate 2 can be made thinner. In addition, adding a material that has a higher thermal conductivity than the substrate 2 lowers the overall thermal resistance.

The thicknesses of the additional layers 4a and 4b are preferably 10 µm or less and more preferably 5 µm or less. Further, the thicknesses of the additional layers 4a and 4b are preferably 0.5 µm or more. When the thicknesses of the additional layers 4a and 4b exceed 10 µm, cracks occur more easily in a semiconductor packaging during power cycle (PC) testing and reliability is lower, and when the thicknesses are smaller than 0.5 µm, the additional layers deform easily due to stress from the porous conductive layer.

The coefficient of linear expansion of the additional layer 4a is preferably equal to or greater than the coefficient of linear expansion of the insulating layer 20 and preferably equal to or less than the coefficient of linear expansion of the wiring 3. Making the coefficient of linear expansion equal to or greater than that of the insulating layer 20 can alleviate the reduction in reliability when cracking is generated in the semiconductor packaging by focusing the stress between the additional layer 4a and the wiring 3 caused by changes in dimensions that accompany temperature change. Further, making the coefficient of linear expansion to be equal to or less than that of the wiring 3 can alleviate the reduction in reliability when cracking is generated in the semiconductor packaging by focusing the stress between the additional layer 4a and the substrate 2 caused by changes in dimensions that accompany temperature change. Similarly, the coefficient of linear expansion of the additional layer 4b is preferably equal to or greater than the coefficient of linear expansion of the insulating layer 20 and preferably equal to or less than the coefficient of linear expansion of the metal thin film 5.

The wiring 31 and 32 and the additional layer 4a, as illustrated in FIG. 1, have surface areas of the surface opposite the surface of the substrate 2 side that are smaller than the surface area of the surface of the substrate 2 side, respectively, and the side surface that connects the surface of the substrate 2 side and the surface opposite the surface of the substrate 2 side forms a tapered shape that curves inward. Further, the surface area differs for all layers provided on the wiring 3 side on the substrate 2 by the surface of the substrate 2 side, that is, the bottom surface in FIG. 1 of the additional layer 4a, and the surface opposite the surface of the substrate 2 side, that is, the top surface in FIG. 1 of the wiring 3, in that the surface area of the bottom surface of the additional layer 4a is larger.

In this manner, in addition to allowing the heat dissipation effect to be improved, adhesion with the sealing resin can be made favorable without increasing the thickness of the layers provided on the substrate 2 and reliability can be improved, because the surface area of the side surface that connects to the surface of the substrate 2 side and the surface opposite the surface of the substrate 2 side increases due to a difference in surface area between the surface of the substrate 2 side and the surface opposite the surface of the substrate 2 side.

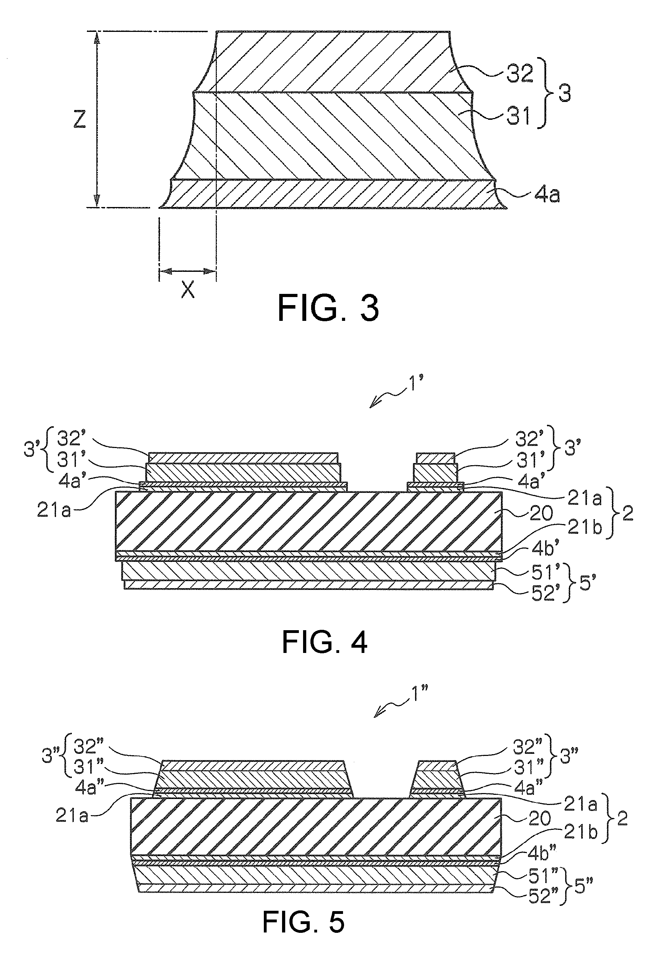

Additionally, as illustrated in FIG. 3, preferably z/x is less than or equal to 10, when z is defined as the total thickness of all layers provided on the wiring 3 side on the substrate 2, and x is defined as a protruding length in one direction relative to the surface opposite the surface of the substrate 2 side of the surface of the substrate 2 side for all layers provided on the wiring 3 side on the substrate 2. In this manner, heat dissipation and adhesion with the sealing resin can be further improved.

Further, the metal thin films 51 and 52 and the additional layer 4b, as illustrated in FIG. 1, respectively, also preferably have surface areas of the surface opposite the surface of the substrate 2 side that are smaller than the surface area of the surface of the substrate 2 side, and the side surface that connects the surface of the substrate 2 side and the surface opposite the surface of the substrate 2 side forms a tapered shape that curves inward. Further, the surface area differs for all layers provided on the metal thin film 5 side on the substrate 2 by the surface of the substrate 2 side, that is, the bottom surface in FIG. 1 of the additional layer 4b, and the surface opposite the surface of the substrate 2 side, that is the top surface in FIG. 1, of the metal thin film 5, in that the surface area of the top surface of the additional layer 4b is preferably larger. In this manner, heat dissipation and adhesion with the sealing resin can be further improved.

Additionally, preferably z/x is less than or equal to 10, when z is defined as the total thickness of all layers provided on the metal thin film 5 side on the substrate 2, and x is defined as a protruding length in one direction relative to the surface opposite the surface of the substrate 2 side of the surface of the substrate 2 side for all layers provided on the metal thin film 5 side on the substrate 2. In this manner, heat dissipation and adhesion with the sealing resin can be further improved. Moreover, when the wiring has a tapered shape, the value of z/x for the porous conductive layer can be smaller than other layers. The porous conductive layer is provided to have an adhesion improvement effect and heat dissipation effect that are higher than other layers, because the layer has vacancies.

Note that, in the present embodiment, the surface area of the surface of the substrate 2 side is larger than the surface area of the surface opposite the surface of the substrate 2 side, but the opposite is also possible. However, from a perspective of the adhesive force between the layers, it is preferable for the surface area of the surface of the substrate 2 side to be larger. Further, in the present embodiment, the wirings 31 and 32 and the additional layer 4a, as well as the metal thin films 51 and 52 and the additional layer 4b have a tapered shape, which is to say that the four sides that configure the surface of the substrate 2 side are formed so as to be longer than the respective four sides that configure the surface opposite the surface of the substrate 2 side, but the lengths of either the vertical or horizontal sides from among the four sides that configure the surface of the substrate 2 side may be longer.

Further, as long as the surface areas for the surface of the substrate 2 side and the surface opposite the surface of the substrate 2 side are different for all layers provided on at least the wiring 3 side on the substrate 2, the wirings 31 and 32 and the additional layer 4a, respectively, are not required to have a surface area for the surface opposite the surface of the substrate 2 side that is smaller than the surface area of the surface of the substrate 2 side, and, as illustrated in FIG. 4, the surface areas may differ for each layer of the wiring 31' and 32' and the additional layer 4a'. In this case, the surface areas are also preferably made to differ for each layer of the metal thin films 5' and 52' and the additional layer 4b' as illustrated in FIG. 4.

Furthermore, the wirings 31 and 32 and the additional layer 4a, in the example illustrated in FIG. 1, have surface areas of the surface opposite the surface of the substrate 2 side smaller than the surface areas of the surface of the substrate 2 side, respectively, and the side surface that connects the surface of the substrate 2 side and the surface opposite the surface of the substrate 2 side forms a tapered shape that curves inward. However, as illustrated in FIG. 5, the wirings 31" and 32"and the additional layer 4a" may have a tapered shape where the side surface that connects the surface of the substrate 2 side and the surface opposite the surface of the substrate 2 side is linear without curving inward. In this case, the metal thin films 51" and 52"and the additional layer 4b", as illustrated in FIG. 5, also preferably have a tapered shape where the side surface that connects the surface of the substrate 2 side and the surface opposite the surface of the substrate 2 side is linear.

However, for the tapered shape, the shape as illustrated in FIG. 1 where the side surface has a curved shape, or alternatively, the stepped shape as illustrated in FIG. 4, are preferred over the side surface as illustrated in FIG. 5 having a linear shape, because the bonding surface area is improved and the area of the heat dissipation portion is increased. Furthermore, the side surface as illustrated in FIG. 1 having a curved shape is preferred in that it is easier to produce.

### <Method for Manufacturing the Wiring Substrate 1 >

Next, a method for manufacturing the wiring substrate 1 according to the present embodiment is described.

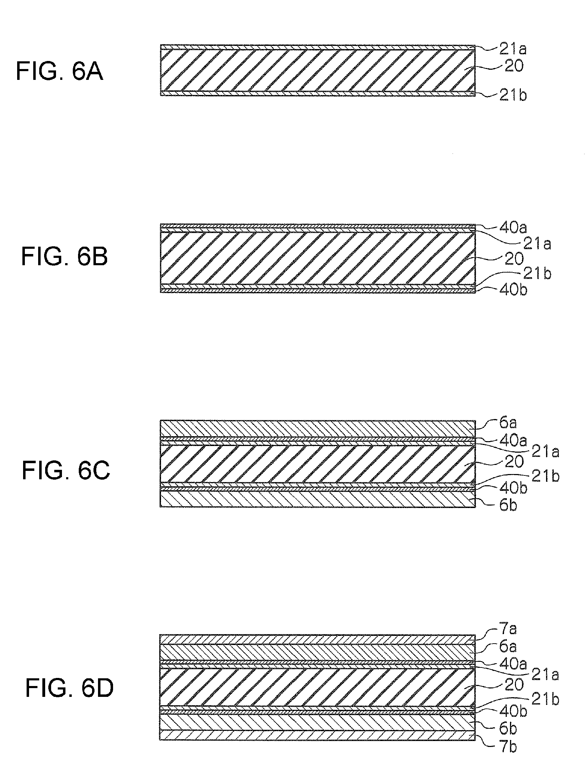

First, as illustrated in FIG. 6A, foundation layers 21a and 21b are formed on an insulating layer 20. A method for forming the foundation layers 21a and 21b may be suitably selected from vacuum thin film coating, plating, high temperature application of metal foil, and the like. Note that the insulating layer 20 may be pretreated so as to improve adhesion between the insulating layer 20 and the foundation layers 21a and 21b. As a pretreatment, there is a plasma treatment, for example. The plasma treatment can clean and activate the top surface of the insulating layer 20.

Next, as illustrated in FIG. 6B, metal thin films 40a and 40b that constitute additional layers 4a and 4b are formed on the foundation layers 21a and 21b of the substrate 2. A method for forming the metal thin films 40a and 40b may be suitably selected from vacuum thin film coating, plating, high temperature application of metal foil, and the like.

Next, a first wiring 31 and a first metal thin film 51, as well as a second wiring 32 and a second metal thin film 52, are formed. As one example of a method to form the first wiring 31 and the first metal thin film 51, there is a method that performs a heat treatment after supplying metallic fine particles 6a and 6b on the metal thin films 40a and 40b. In this case, as illustrated in FIG. 6C, the metallic fine particles 6a and 6b are supplied on the metal thin films 40a and 40b, and as illustrated in FIG. 6D, a metal thin film 7a, which is a material of the second wiring 32, and a metal thin film 7b that forms the second metal thin film 52 are respectively laminated on the supplied metallic fine particles 6a and 6b. The metallic fine particles 6a and 6b are sintered by heating in this state. At this time, particles of the metallic fine particles 6a and 6b are bonded mutually together to form a porous conductive layer, and the metallic fine particles 6a and the metal thin film 7a, as well as the metallic fine particles 6b and the metal thin film 7b, are also bonded. Because the temperature required for sintering is about 300°C, which is different and significantly lower than the temperature required to join a copper circuit to a DBC substrate (about 1000°C), residual stress generated in a wiring 3 in a process to form the wiring 3 can be decreased remarkably.

Sintering the metallic fine particles 6a and 6b is preferably carried out in a reducing atmosphere or an inert atmosphere. An inert atmosphere is an atmosphere filled with a gas such as nitrogen or is a vacuum atmosphere. Doing so can prevent oxidation of the first wiring 31 and the first metal thin film 51. Moreover, it becomes possible to remove an oxidized layer on a top surface of the metallic fine particles 6a and 6b and improve sinterability of the metallic fine particles 6a and 6b. Further, sintering is preferably performed while suitably applying pressure, depending on the use of the substrate 2 and the properties of a dispersed material mixed into the metallic fine particles 6a and 6b.

As cases where it is desired to sinter the metallic fine particles 6a and 6b by heating while applying pressure, there is a case where heating volatilizes the dispersing agent and greatly decreases the occupied volume of the metallic fine particles 6a and 6b, and a case where metallic fine particles 6a and 6b do not sufficiently join to an upper layer merely by heating. Applying pressure can prevent cracks from forming in the porous conductive layer in cases where heating remarkably decreases the occupied area of the metallic fine particle 6a and 6b. Further, when bondability is insufficient between the metallic fine particles 6a and 6b and the upper layer or the lower layer, applying pressure can firmly join both layers.

As cases where it is desired to sinter the metallic fine particles 6a and 6b by heating without applying pressure, there is a case where the surface area occupied by the metallic fine particles 6a and 6b hardly changes even when heated, a case where the surface tension between the metallic fine particles 6a and 6b is extremely small, causing condensing during heating, and a case where the bondability between the metallic fine particles 6a and 6b and the upper layer or lower layer is extremely favorable.

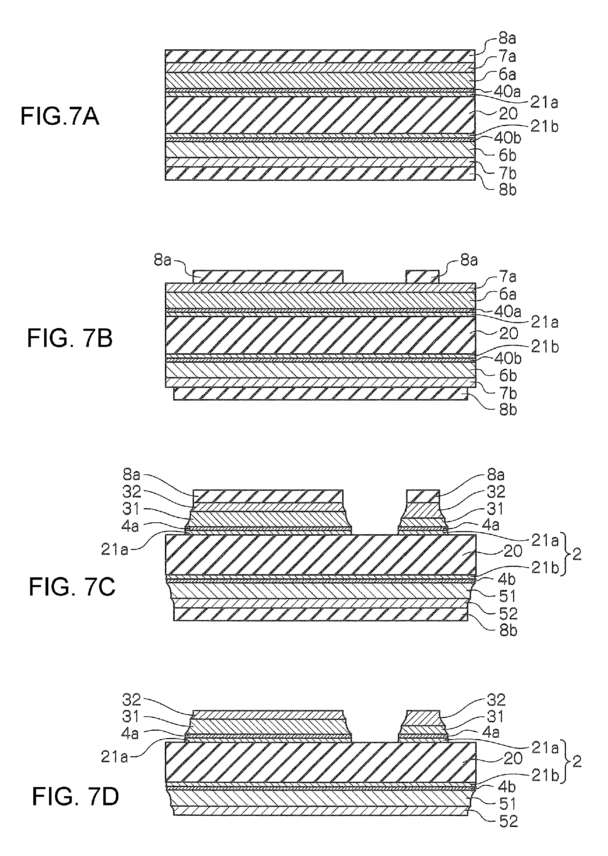

Lastly, the wiring 3 is formed by patterning a layer made of a sintered body of the metallic fine particles 6a (porous conductive layer) and the metal thin film 7a. A photolithography process can be given as one example of a patterning method. As illustrated in FIG. 7A, exposure is performed via a mask having a predetermined pattern after applying a photosensitive plating resist 8a on the metal thin film 7a by means of laminating or the like. Next, as illustrated in FIG. 7B, developing is performed in a developing solution suited to the properties of the plating resist 8a. Then, as illustrated in FIG. 7C, patterning is performed by exposing the layer including the sintered body of the metallic fine particles 6a, the metal thin film 7a, the additional layer 4a, and the foundation layer 21a to a soluble etching solution to form the second wiring 32 and the first wiring 31. A plurality of etching solutions is used as needed if the second wiring 32, the first wiring 31, and the foundation layer 21a are not made of the same metal.

At this time, in an etching process, setting the pressure at which the etching fluid is sprayed in a shower method to about 0.06 MPa and raising an etching anisotropy between the substrate thickness direction and the substrate planar direction, the surface areas of the surfaces of the wirings 31 and 32 and the additional layer 4a, opposite the surface of the substrate 2 side, respectively, become smaller than the surface area of the surface of the substrate 2 side, and the side surface that connects to the surface of the substrate 2 side and the surface opposite the surface of the substrate 2 side becomes a tapered shape that curves inward, as illustrated in FIG. 7C. Further, the surface area of the surface of the substrate 2 side across all layers provided on the wiring 3 side on the substrate 2 becomes greater than the surface area of the surface opposite the surface of the substrate 2 side. The spraying pressure of the etching fluid suitable for forming a circuit in a tapered shape varies according to the fluid used, the crystal structure of the material to be etched, the type of etching fluid, and the like. Accordingly, to manufacture the tapered shape, it is favorable to lower the spraying pressure compared to when manufacturing a circuit shape without a taper.

Further, when applying a plating resist 8b on the second metal thin film 52 when applying the plating resist 8a on the metal thin film 7a as illustrated in FIG. 7A, and exposing and developing so as to remove an end portion of the resist 8b as illustrated in FIG. 7B, the metal thin films 51 and 52 and the additional layer 4a, as illustrated in FIG. 7C, have surface areas of the surface opposite the surface of the substrate 2 side that are, respectively, smaller than the surface area of the surface of the substrate 2 side and the side surface that connects the surface of the substrate 2 side and the surface opposite the surface of the substrate 2 side forms a tapered shape that curves inward. Further, the surface area of the surface of the substrate 2 side across all layers provided on the wiring 3 side on the substrate 2 becomes greater than the surface area of the surface opposite the surface of the substrate 2 side.

Further, as illustrated in FIG. 4, when varying the surface area of each layer of wirings 31' and 32' and an additional layer 4a' and of metal thin films 51' and 52' and an additional layer 4b', it is favorable to add means to provide a new etching resist in a desired shape at each etching of the layers or to add a second etching for the layers to obtain a desired shape after etching the layers. Further, as illustrated in FIG. 5, when making a tapered shape wherein the side surface that connects the surface of the substrate 2 side and the surface opposite the surface of the substrate 2 side forms a straight line, it is favorable to use a uniform etching rate on the layers across the entire process.

After forming the pattern, the plating resists 8a and 8b are peeled away with a peeling fluid to complete the wiring substrate 1 as illustrated in FIG. 7D.

### <Usage Example of the Wiring Substrate 1>

Next, as a usage example of the wiring substrate 1 according to the present embodiment, a semiconductor device 10 mounted with a semiconductor element 9 in the wiring substrate 1 according to the present embodiment is described.

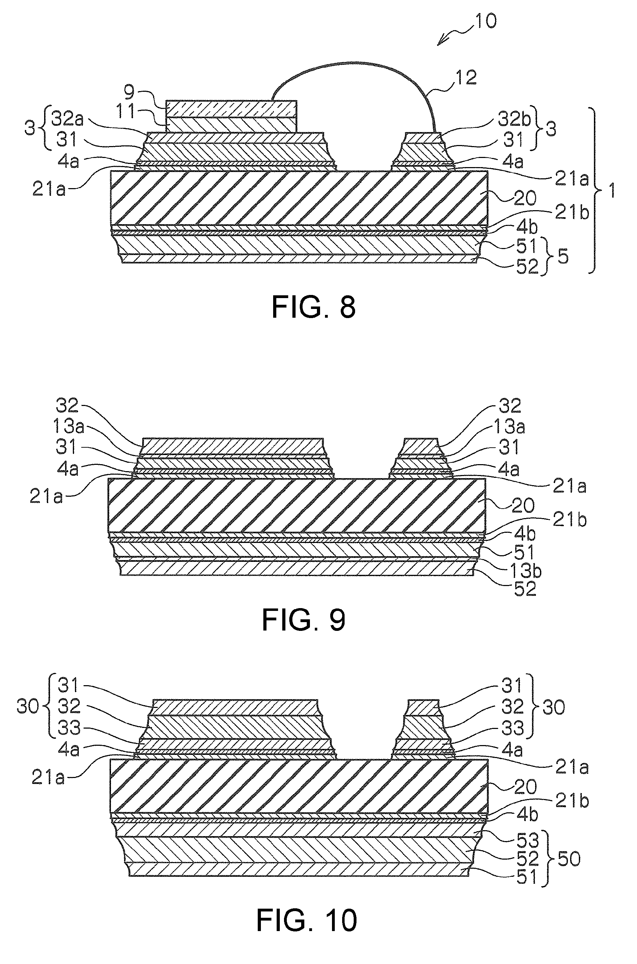

As illustrated in FIG. 8, a terminal (not illustrated) formed on a surface on one side of the semiconductor element 9 (the surface on the lower side in FIG. 5) is connected to a second wiring 32a of the wiring substrate 1 via an element connecting porous conductive layer 11 having a plurality of vacancies inside. Further, a terminal (not illustrated) formed on a surface on another side of the semiconductor element 9 (the surface on the upper side in FIG. 5) is connected to the second wiring 32b of the wiring substrate 1 by a wire 12.

The element connecting porous conductive layer 11 is configured from a similar material as the first wiring 31 and the first metal thin film 51. By connecting the wiring substrate 1 and the semiconductor element 9 via the element connecting porous conductive layer 11, the apparent modulus of elasticity decreases because the heat stress accompanying expansion is not transferred to other layers due to deformation of the layer having vacancies even if a metal configuring the wiring 3 expands due to heat. Further, even if stress is caused in the semiconductor device by differences in coefficients of linear expansion of the semiconductor element 9, the wiring substrate 1, and the wiring 3, the stress is mitigated because it is absorbed by the vacancies. Therefore, peeling or cracking that occurs between the semiconductor element 9 and the wiring substrate 1 can be decreased. Further, the connecting material does not become brittle due to high-temperature operation of the semiconductor element because a brazing filler material (solder) is not used, unlike conventional connections of DBC substrates and semiconductor elements.

### <Modified Example>

In the embodiment described above, the second wiring 32 was provided on the first wiring 31, however, as illustrated in FIG. 9, an adhesive layer 13a for improving adhesion with the first wiring 31 may be provided on a surface on the first wiring 31 side of the second wiring 32. Moreover, as illustrated in FIG. 9, an adhesive layer 13b for improving adhesion with the first metal thin film 51 may be provided on the surface on the metal thin film 51 side of the second metal thin film 52. The adhesive layers 13a and 13b are made of metal, and Au, Ti, Cr, Cu, Ni, Ag, and the like may be suitably used. A thickness of the adhesive layers 13a and 13b is preferably 0.01 to 1 µm.

Further, in the embodiment described above, the wiring 3 and the metal thin film 5 were respectively configured in two layers, however, as illustrated in FIG. 10, they may be configured in three layers, with an upper and lower layer, that is, layers other than a middle layer, respectively configured from a porous conductive layer having a plurality of vacancies inside. That is, the wiring 30 is laminated on the additional layer 4a in order of the third wiring 33, the second wiring 32, and the first wiring 31, and the metal thin film 50 is laminated on the additional layer 4b in order of the third metal thin film 53, the second metal thin film 52, and the first metal thin film 51. The third wiring 33 is then configured from a similar material as the first wiring 31, and the third metal thin film 53 is configured from a similar material as the first metal thin film 51. Note that when configuring the wiring 30 in three layers as above, the thickness of the insulating layer 20 may be made thinner, and in this case, the second wiring 32, which is the layer other than the porous conductive layers, may be made thicker in the same amount by which the thickness of the insulating layer 20 was made thinner. At this time, a ratio of the thickness of the substrate 2 relative to the second wiring 32 (thickness of the substrate 2 / thickness of the second wiring 32) is preferably 1.5 or less when using Al₂O₃ or AlN as the insulating layer 20, and a ratio of the thickness of the substrate 2 relative to the second wiring 32 (thickness of the substrate 2 / thickness of the second wiring 32) is 0.25 or less when using Si3N4 as the insulating layer 20.

Further, in the embodiment described above, the additional layer 4b, the first metal thin film 51, and the second metal thin film 52 are provided on the surface opposite the wiring 3 side of the substrate 2, however, these may also not be provided.

Further, in the embodiment described above, the foundation layers 21a and 21b are provided to both surfaces of the insulating layer 20, however, these may be provided on one surface or not provided on either surface.

Further, in the embodiment described above, the second wiring 32 and the second metal thin film 52 are provided, however, one or both may also not be provided.

Further, the surface area of the surface opposite the insulating layer of the wiring may be formed to be large compared to inverting the shape of a taper described below, that is, compared to the reverse surface of the surface opposite the insulating layer of the wiring, by etching the wiring portion from the insulating layer side.

Further, a processing layer processed to cause atomic vacancy and/or dislocation may be provided on the top surface of the layers to increase bondability with other layers. The forming of the processing layer is not limited as long as atomic vacancy and/or dislocation is caused on the top surface of the layers and, for example, may be done through damage by radiation by particle beam irradiation.

The processing layer is the layer formed on the insulating layer 20 and may be provided on the entire surface that contacts other layers, however, this layer is preferably provided on the top surface on the porous conductive layer side of the additional layers 4a and 4b, the top surface on the porous conductive layer side of the second wiring 32, and the top surface on the porous conductive layer side of the second metal thin film 52, particularly to improve adhesion of the porous conductive layers with the other layers. When providing the processing layer to the additional layers 4a and 4b, it is favorable to apply the process that causes atomic vacancy and/or dislocation on the top surface of the metal thin films 40a and 40b after forming the metal thin films 40a and 40b, which will be the additional layers 4a and 4b, on the foundation layers 21a and 21b of the substrate 2 and before supplying the metallic fine particles 6a and 6b on the metal thin films 40a and 40b. Further, when providing the processing layer to the second wiring 32 or to the second metal thin film 52, it is favorable to apply the process that causes atomic vacancy and/or dislocation in advance at least on the surface on the side to be disposed on the metallic fine particles 6a and 6b of the metal thin film 7a, which is the material of the second wiring 32, and the metal thin film 7b, which forms the second metal thin film 52. In this manner, when sintering the metallic fine particles 6a and 6b, a melting phenomenon occurs locally on the top surface of the metallic fine particles, forming the bonded portion (neck) between the metallic fine particles and between the metallic fine particles and the processed metal thin films. At this time, higher adhesion is obtained and bonding at lower temperatures is enabled, because the processed metal thin films have the processing layer processed to cause atomic vacancy and/or dislocation on at least the top surface, and because the dispersion that accompanies movement of the atomic vacancies of the processing layer to the entirety of the bonded material or to the metallic fine particles is prompted between the metallic fine particles and the processed metal thin films, similar to the neck between the metallic fine particles, and the metallic fine particles and the neck grow. As a result, heat stress, delamination due to strain, and the progression of cracking can be prevented.

### <Working Examples>

Next, working examples of the present invention are described, but the present invention is not limited to these working examples.

The wiring substrate according to working examples 1 to 7 having layers with thicknesses as shown in Table 1 (the unit in each case is µm) was manufactured as below. Note that in Table 1, "-" indicates that no layer was provided.

A powder sintered body of Al₂O₃ was used as the insulating layer, and the foundation layers were formed by vapor deposition of copper by sputtering on both surfaces of this insulating layer. Note that for working example 1 and working example 4, the process to form the foundation layers was not performed.

Next, the nano copper paste was coated on both foundation layers formed on both surfaces of the substrate for working examples 2, 3, and 5 to 7, and on both surfaces of the substrate for working examples 1 and 4. The nano copper paste that was used had copper particles of an average particle size of 20 nm as metallic fine particles dispersed in a dispersing agent (diethylene glycol), with a thickening agent (polyvinyl pyrrolidone) added thereto. For working examples 3 and 7, gold foil, and then copper strips, were disposed on the nano copper paste, and for working examples 1, 2, and 4 to 6, copper strips were disposed on the nano copper paste. After this, the copper particles in the nano copper paste were sintered by applying heat and pressure for ten minutes at 320°C and 5 MPa in an atmosphere filled with nitrogen gas to obtain a laminated body having laminated on both surfaces of the substrate, in order, the foundation layer (none for working examples 1 and 4), the layer including a sintered body of the copper particles, the thin film layer of gold (only for working examples 3 and 7), and the copper layer.

Next, on both surfaces of the laminated body described above, the etching resist was laminated by applying heat and pressure for thirty seconds at 100°C and 0.1 MPa. The mask corresponding to the wiring pattern was then applied to the surface on the side forming the wiring, and exposure and development are performed. After this, etching was performed, removing the unnecessary portion of the copper layer, the thin film layer of gold, and the layer including the sintered body of the copper particles, of the surface of the side where the wiring is to be formed, to form the wiring. After this, the etching resist was peeled away to obtain the wiring substrate according to the working examples.

Further, wiring substrates according to comparative examples 1 and 2 having layers with thicknesses shown in Table 1 (the unit in each case is µm) were created as below.

The wiring substrate according to the comparative examples was obtained by using the powder sintered body of Al₂O₃ as the insulating layer, heating to 800°C the Ag 71 %-Cu 27%-Ti 2%, corresponding to a thickness after congealing of 5 µm in comparative example 1 and 50 µm in comparative example 2, bonding to both surfaces of this insulating layer 300 µm of copper in comparative example 1 and 250 µm of copper in comparative example 2, while in a molten state, and then congealing the Ag 71 %-Cu 27%-Ti 2% by cooling.

### <Evaluation Test>

### (Occurrence of Cracking and the like)

The Sn-0.1 Ag-0.7 Cu solder was heated to 240°C and supplied on the wiring substrate according to working examples 1 to 7 and comparative examples 1 and 2.

The semiconductor element was placed on the wiring substrate supplied with the solder and heated at 240°C for 0.5 minutes to connect a terminal formed on the surface on one side of the semiconductor element and the wiring of the wiring substrate. After this, the terminal formed on the surface on the other side of the semiconductor element was connected to the wiring of the wiring substrate by wire bonding. A semiconductor element having a surface area of 5 mm x 5 mm and a thickness of 0.23 mm was used.

After 100 semiconductor packages using the working examples and the comparative examples obtained as above were held at -60°C for 30 minutes, a heat cycle test that repeats a cycle of increasing the temperature to 200°C and holding for 30 minutes for 3000 cycles was performed. After this, each semiconductor package was cut in the thickness direction, observed using an SEM (scanning electron microscope), and evaluated for the presence or absence of cracks or delamination. Results of the evaluation are shown in Table 1. Those without cracks of 0.01 mm or more or delamination of 0.01 mm or more are indicated as "None," and those with one or more occurring are indicated as "Yes."

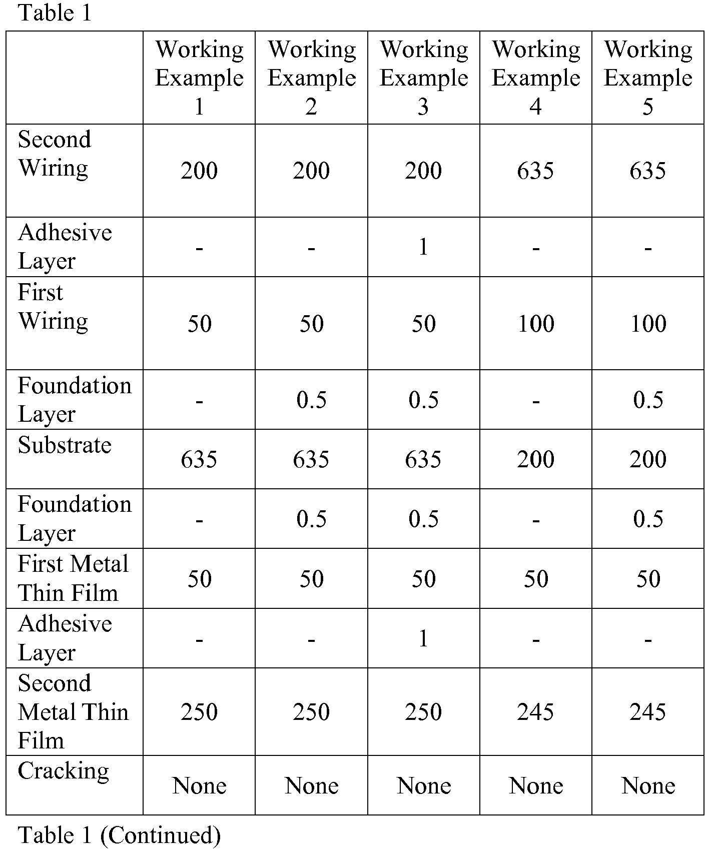

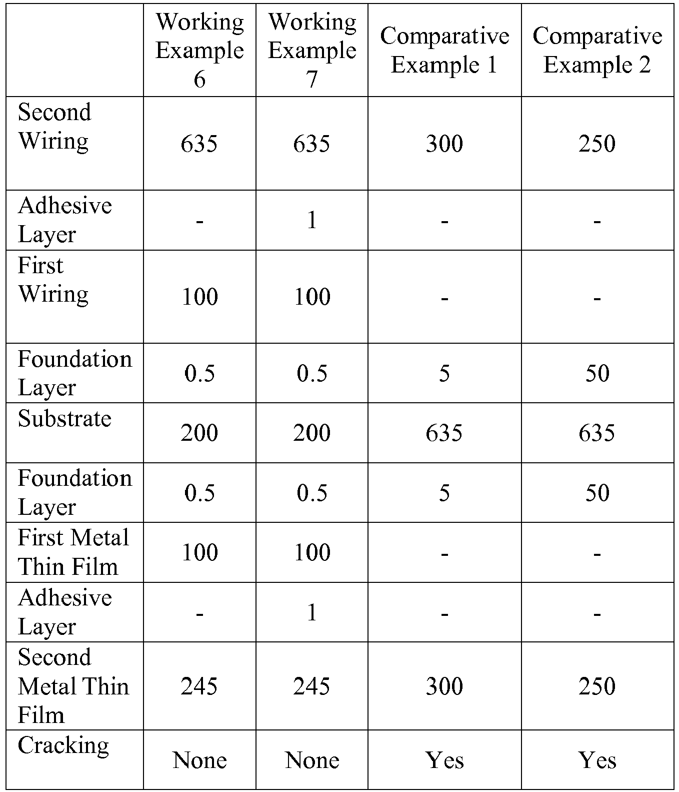

The working examples 1 to 7 have the first wiring with the plurality of vacancies inside, and because this first wiring mitigates stress, cracks or delamination did not occur even after 3000 cycles of the heat cycle test. Meanwhile, because the comparative examples 1 and 2 do not have the first wiring with the plurality of vacancies inside, the stress was not mitigated, and cracks or delamination occurred as a result of the heat cycle test.

### (Working Example 8)

Further, the wiring substrate according to working example 8 having layers with thicknesses indicated in Table 2 was manufactured as below. A powder sintered body of Al₂O₃ was used as the insulating layer, and foundation layers were formed by depositing Ti by sputtering on both surfaces of this insulating layer. Moreover, the additional layers were formed by film deposition of Cu by sputtering and plating on both foundation layers.

Next, the nano copper paste was coated on both additional layers. The nano copper paste that was used had copper particles of an average particle size of 20 nm as metallic fine particles dispersed in a dispersing agent (diethylene glycol), with a thickening agent (polyvinyl pyrrolidone) added thereto. Copper strips having a gold layer on the surface were disposed on the nano copper paste and then the copper particles in the nano copper paste were sintered by applying heat and pressure for ten minutes at 320°C and 5 MPa in an atmosphere filled with nitrogen gas to obtain a laminated body having laminated on both surfaces of the substrate, in order, the foundation layer, the additional layer, the layer including a sintered body of the copper particles, the thin film layer of gold, and the copper layer.

Next, on both surfaces of the laminated body described above, the etching resist was laminated by applying heat and pressure for thirty seconds at 100°C and 0.1 MPa. The mask corresponding to the wiring pattern was then applied to the surface on the side forming the wiring, the mask was applied to the surface on the side forming the metal thin film so as to remove the end portion of the resist, and exposure and development were performed. After this, etching was performed, removing the unnecessary portion of the layer including the copper layer, the thin film layer of gold, the layer including the sintered body of the copper particles, the additional layers, and the foundation layers to form the wiring and the metal thin film. The etching was performed at a pressure setting of 0.06 MPa by the shower method for all processes. After this, the etching resist was peeled away to obtain the wiring substrate according to the working example. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 2. The modulus of elasticity of each layer was as shown in Table 2. The modulus of elasticity was determined based on the pressure similar to the substrate manufacturing conditions and the stress-strain curve obtained from a tensile test of the material of the layers applied with the temperature profile.

### (Working Example 9)

The wiring substrate according to working example 9 was obtained in the same manner as working example 8 except in the points below. Etching was performed in working example 9 in the same manner as working example 8, and after removing the unnecessary portion of the copper layer, the thin film layer of gold, the layer including the sintered body of the copper particles, the additional layers, and the foundation layers, an etching resist capable of achieving the intended dimensions of the layers was again formed, and the layers were again etched. Upon cutting the wiring substrate in the thickness direction and observing the shape thereof by SEM, the surface area of the first wiring and the surface area of the additional layers were greater than the surface area of the second wiring and the surface area of the first wiring, respectively; the surface area of the first metal thin film and the surface area of the additional layers were greater than the surface area of the second metal thin film and the first metal thin film, respectively; and the shape thereof was formed with steps at each layer, that is, the shape illustrated in FIG. 4. Further, measuring the size of the upper surface of the second wiring, the foundation layers, and the lower surface of the second metal thin film yielded the results shown in Table 2. Further, measuring the modulus of elasticity of each layer yielded the results shown in Table 2.

### (Working Example 10)

The wiring substrate according to working example 10 was obtained in the same manner as working example 8 except in the points below. In working example 10, in the etching process of all the layers in working example 8, the spraying pressure in the shower method was set to 0.05 MPa at etching commencement, and the pressure was continuously increased with 0.08 MPa as the upper limit until etching termination. After cutting the wiring substrate in the thickness direction and observing the shape thereof by SEM, the surface area of the surface opposite the surface of the substrate side was smaller than the surface area of the surface of the substrate side for the first wiring, the second wiring, the additional layers, the first metal thin film, and the second metal thin film, respectively, which had become the tapered shape with the side surface thereof connecting the surface of the substrate side and the surface opposite the surface of the substrate side in a straight line, that is, the shape illustrated in FIG. 5. Further, measuring the size of the upper surface of the second wiring, the foundation layers, and the lower surface of the second metal thin film yielded the results shown in Table 2. Further, measuring the modulus of elasticity of each layer yielded the results shown in Table 2.

### (Working Example 11)

The wiring substrate according to working example 11 was obtained in the same manner as working example 8 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 2. Further, measuring the modulus of elasticity of each layer yielded the results shown in Table 2.

### (Working Example 12)

The wiring substrate according to working example 12 was obtained in the same manner as working example 8 except for changing the thickness of the first and second wirings and the first and second metal thin films. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 3. Further, measuring the modulus of elasticity of each layer yielded the results shown in Table 3.

### (Working Example 13)

Further, the wiring substrate according to working example 13 having the layers with thicknesses indicated in Table 3 was manufactured as below. A powder sintered body of Al₂O₃ was used as the insulating layer, and foundation layers were formed by depositing Ti by sputtering on both surfaces of this insulating layer. Moreover, the additional layers were formed by vapor deposition of Ag by sputtering on both foundation layers.

Next, nano aluminum paste was coated on both additional layers. The nano aluminum paste that was used had aluminum particles of an average particle size of 20 nm as metallic fine particles dispersed in the dispersing agent (diethylene glycol), with the thickening agent (polyvinyl pyrrolidone) added thereto. Aluminum strips having a gold layer on the surface were disposed on the nano aluminum paste and then the aluminum particles in the nano aluminum paste were sintered by applying heat and pressure for ten minutes at 320°C and 5 MPa in an atmosphere filled with nitrogen gas to obtain a laminated body having laminated on both surfaces of the substrate, in order, the foundation layer, the additional layer, the layer including a sintered body of the aluminum particles, the thin film layer of gold, and the copper layer.

Next, on both surfaces of the laminated body described above, the etching resist was laminated by applying heat and pressure for thirty seconds at 100°C and 0.1 MPa. The mask corresponding to the wiring pattern was then applied to the surface on the side forming the wiring, the mask was applied to the surface on the side forming the metal thin film so as to remove the end portion of the resist, and exposure and development were performed. After this, etching was performed, removing the unnecessary portion of the layer including the aluminum layer, the thin film layer of gold, the layer including the sintered body of the aluminum particles, the additional layers, and the foundation layers to form the wiring and the metal thin film. The etching was performed at a pressure setting of 0.06 MPa by the shower method for all processes. After this, the etching resist was peeled away to obtain the wiring substrate according to the working example. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 3. The modulus of elasticity of each layer is as shown in Table 3.

### (Working Example 14)

The wiring substrate according to working example 14 was obtained in the same manner as working example 8 except for forming the additional layers from Mn. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 3. Further, measuring the modulus of elasticity of each layer yielded the results shown in Table 3.

### (Working Example 15)

The wiring substrate according to working example 15 was obtained in the same manner as working example 8 except for setting the thickness of the additional layers as 15 µm. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 3. Further, measuring the modulus of elasticity of each layer yielded the results shown in Table 3.

### (Working Example 16)

The wiring substrate according to working example 16 was obtained in the same manner as working example 14 except for setting the thickness of the additional layers as 15 µm. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 4. Further, measuring the modulus of elasticity of each layer yielded the results shown in Table 4.

### (Working Example 17)

The wiring substrate according to working example 17 was obtained in the same manner as working example 8 except for forming the additional layers from Al. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 4. Further, measuring the modulus of elasticity of each layer yielded the results shown in Table 4.

### (Working Example 18)

The wiring substrate according to working example 18 was obtained in the same manner as working example 8 except for not providing the additional layers. Upon cutting the wiring substrate in the thickness direction and observing the shape thereof by SEM, the surface area of the surface opposite the surface of the substrate side was smaller than the surface area of the surface of the substrate side for the first wiring, the second wiring, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 4. Further, measuring the modulus of elasticity of each layer yielded the results shown in Table 4.

### (Working Example 19)

The wiring substrate according to working example 19 was obtained in the same manner as working example 14 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 4. Further, measuring the modulus of elasticity of each layer yielded the results shown in Table 4.

### (Working Example 20)

The wiring substrate according to working example 20 was obtained in the same manner as working example 8 except for setting the thickness of the additional layers as 15 µm and setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 5. Further, measuring the modulus of elasticity of each layer yielded the results shown in Table 5.

### (Working Example 21)

The wiring substrate according to working example 21 was obtained in the same manner as working example 16 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 5. Further, measuring the modulus of elasticity of each layer yielded the results shown in Table 5.

### (Working Example 22)

The wiring substrate according to working example 22 was obtained in the same manner as working example 17 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 5. Further, measuring the modulus of elasticity of each layer yielded the results shown in Table 5.

### (Working Example 23)

The wiring substrate according to working example 23 was obtained in the same manner as working example 18 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 5. Further, measuring the modulus of elasticity of each layer yielded the results shown in Table 5.

### (Working Example 24)

The wiring substrate according to working example 24 was obtained in the same manner as working example 12 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 6. Further, measuring the modulus of elasticity of each layer yielded the results shown in Table 6.

### (Working Example 25)

The wiring substrate according to working example 25 was obtained in the same manner as working example 13 except for setting the spraying pressure of the etching fluid to be 0.08 MPa. Upon cutting the wiring substrate in the thickness direction and observing the shape thereof by SEM, the surface area of the surface opposite the surface of the substrate side was smaller than the surface area of the surface of the substrate side for the first wiring, the second wiring, the additional layer, the first metal thin film, and the second metal thin film, respectively, which had become the tapered shape with the side surface thereof connecting the surface of the substrate side and the surface opposite the surface of the substrate side by curving inward, that is, the shape illustrated in FIG. 1. Further, measuring the size of the upper surface of the second wiring, the foundation layers, and the lower surface of the second metal thin film yielded the results shown in Table 6. Further, measuring the modulus of elasticity of each layer yielded the results shown in Table 6.

### (Comparative Example 3)

The wiring substrate according to comparative example 3 was obtained in the same manner as working example 8 except for setting the pressure during etching to be 0.20 MPa. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 7. Further, measuring the modulus of elasticity of each layer yielded the results shown in Table 7.

### (Comparative Example 4)

The wiring substrate according to comparative example 4 was obtained in the same manner as comparative example 3 except for not providing the additional layers. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 7. Further, measuring the modulus of elasticity of each layer yielded the results shown in Table 7.

### (Comparative Example 5)

The wiring substrate according to comparative example 5 was obtained in the same manner as comparative example 3 except for forming the additional layers from Al. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 7. Further, measuring the modulus of elasticity of each layer yielded the results shown in Table 7.

### (Comparative Example 6)

The wiring substrate according to comparative example 6 was obtained in the same manner as comparative example 3 except for setting the thickness of the additional layers as 10 µm. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 7. Further, measuring the modulus of elasticity of each layer yielded the results shown in Table 7.

### (Comparative Example 7)

The wiring substrate according to comparative example 7 was obtained in the same manner as comparative example 3 except for setting the thickness of the additional layers as 15 µm. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 7. Further, measuring the modulus of elasticity of each layer yielded the results shown in Table 7.

### (Comparative Example 8)

The wiring substrate according to comparative example 8 was obtained in the same manner as comparative example 3 except for forming the additional layers from Mn and setting the thickness of the additional layers as 15 µm. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 8. Further, measuring the modulus of elasticity of each layer yielded the results shown in Table 8.

### (Comparative Example 9)

The wiring substrate according to comparative example 9 was obtained in the same manner as comparative example 4 except for changing the thickness of the first and second wirings and the first and second metal thin films. Upon cutting the wiring substrate in the thickness direction and observing the shape thereof by SEM, the surface areas of the first and second wirings were the same. Further, the surface areas of the first and second metal thin films were the same. Further, measuring the size of the upper and lower surfaces of each layer yielded the results shown in Table 8. Further, measuring the modulus of elasticity of each layer yielded the results shown in Table 8.

### (Comparative Example 10)

The wiring substrate according to comparative example 10 was obtained in the same manner as comparative example 5 except for changing the thickness of the first and second wirings and the first and second metal thin films. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 8. Further, measuring the modulus of elasticity of each layer yielded the results shown in Table 8.

### (Comparative Example 11)

The wiring substrate according to comparative example 11 having layers of the thicknesses indicated in Table 3 was manufactured as below. A powder sintered body of Al₂O₃ was used as the insulating layer, and foundation layers were formed by depositing Ti by sputtering on both surfaces of this insulating layer.

Next, the nano silver paste was coated on both additional layers. The nano silver paste that was used had silver particles of an average particle size of 20 nm as metallic fine particles dispersed in the dispersing agent (diethylene glycol), with the thickening agent (polyvinyl pyrrolidone) added thereto. Silver strips having a gold layer on the surface were disposed on the nano silver paste and then the silver particles in the nano silver paste were sintered by applying heat and pressure for ten minutes at 320°C and 5 MPa in an atmosphere filled with nitrogen gas to obtain a laminated body having laminated on both surfaces of the substrate, in order, the foundation layer, the additional layer, the layer including a sintered body of the silver particles, the thin film layer of gold, and the silver layer.

Next, on both surfaces of the laminated body described above, the etching resist was laminated by applying heat and pressure for thirty seconds at 100°C and 0.1 MPa. The mask corresponding to the wiring pattern was then applied to the surface on the side forming the wiring, the mask was applied to the surface on the side forming the metal thin film so as to remove the end portion of the resist, and exposure and development were performed. After this, etching was performed, removing the unnecessary portion of the layer including the silver layer, the thin film layer of gold, and the layer including the sintered body of the silver particles to form the wiring and the metal thin film. The etching was performed at a pressure setting of 0.20 MPa by the shower method for all processes. After this, the etching resist was peeled away to obtain the wiring substrate according to comparative example 11. Upon cutting the wiring substrate in the thickness direction and observing the shape thereof by SEM, the surface areas of the first and second wirings were the same. Further, the surface areas of the first and second metal thin films were the same. Further, measuring the size of the upper and lower surfaces of each layer yielded the results shown in Table 8. Further, measuring the modulus of elasticity of each layer yielded the results shown in Table 8.

### (Comparative Example 12)

The wiring substrate according to comparative example 12 was obtained in the same manner as comparative example 11 except for providing the additional layers of Mn. Upon cutting the wiring substrate in the thickness direction and observing the shape thereof by SEM, the surface areas of the first wiring, the second wiring, and the additional layers were the same. Further, the surface areas of the first metal thin film, the second metal thin film, and the additional layers were the same. Further, measuring the size of the upper and lower surfaces of each layer yielded the results shown in Table 8. Further, measuring the modulus of elasticity of each layer yielded the results shown in Table 8.

### <Evaluation Test>

### (Occurrence of Cracking and the Like and of Peeling of the Sealing Resin and the Wiring)

An Sn-0.1 Ag-0.7 Cu solder was heated to 240°C and supplied on the wiring substrate according to working examples 8 to 11 and comparative examples 3 to 8.

The semiconductor element was placed on the wiring substrate supplied with the solder and heated at 240°C for 0.5 minutes to connect a terminal formed on the surface on one side of the semiconductor element and the wiring of the wiring substrate. After this, the module was manufactured by connecting the terminal formed on the surface on the other side of the semiconductor element and the wiring of the wiring substrate by wire bonding, bonding the wiring substrate and the copper base by soldering, and bonding the copper base and the heat sink with heat-resistant grease. A semiconductor element having a surface area of 5 mm x 5 mm and a thickness of 0.23 mm was used. Further, KE-850SH (manufactured by Kyocera, Inc.) was used as the sealing agent, and sealing was performed by molding and heat curing in the transfer mold.

### (Heat Dissipation Effect)

A current was flowed into the semiconductor element so the heat input was 100 W for the module assembled as described above using the wiring substrate according to working examples 8 to 25 and comparative examples 3 to 12, and the temperature of the upper surface of the semiconductor element was measured. The measurement results are shown in Tables 2 to 8.

### (Occurrence of Cracking and the Like and of Peeling of the Sealing Resin and the Wiring)

A power cycle test was performed for 3000 cycles, 3250 cycles, 3500 cycles, and 3750 cycles for 100 modules each assembled as described above using the wiring substrate according to working examples 8 to 25 and comparative examples 3 to 12. The power cycle test repeated as one cycle a set providing an interval where a current with a heat input of 100 W was flowed for 2 seconds and an interval of 18 seconds of not flowing the current. After each cycle, each semiconductor package was cut in the thickness direction, observed by SEM (scanning electron microscope), and evaluated for the presence or absence of cracks or delamination as well as peeling of the sealing resin and the wiring. Note that the observation of the presence or absence of cracks or delamination was performed for 3500 cycles. The results are shown in Tables 2 to 8. Concerning the presence or absence of cracks or delamination, those without cracks of 0.01 mm or more or delamination of 0.01 mm or more are indicated as "None," and those with one or more occurring are indicated as "Yes." Concerning the presence or absence of peeling of the sealing resin and the wiring, those without any are indicated as "None," and those with one or more occurring are indicated as "Yes."

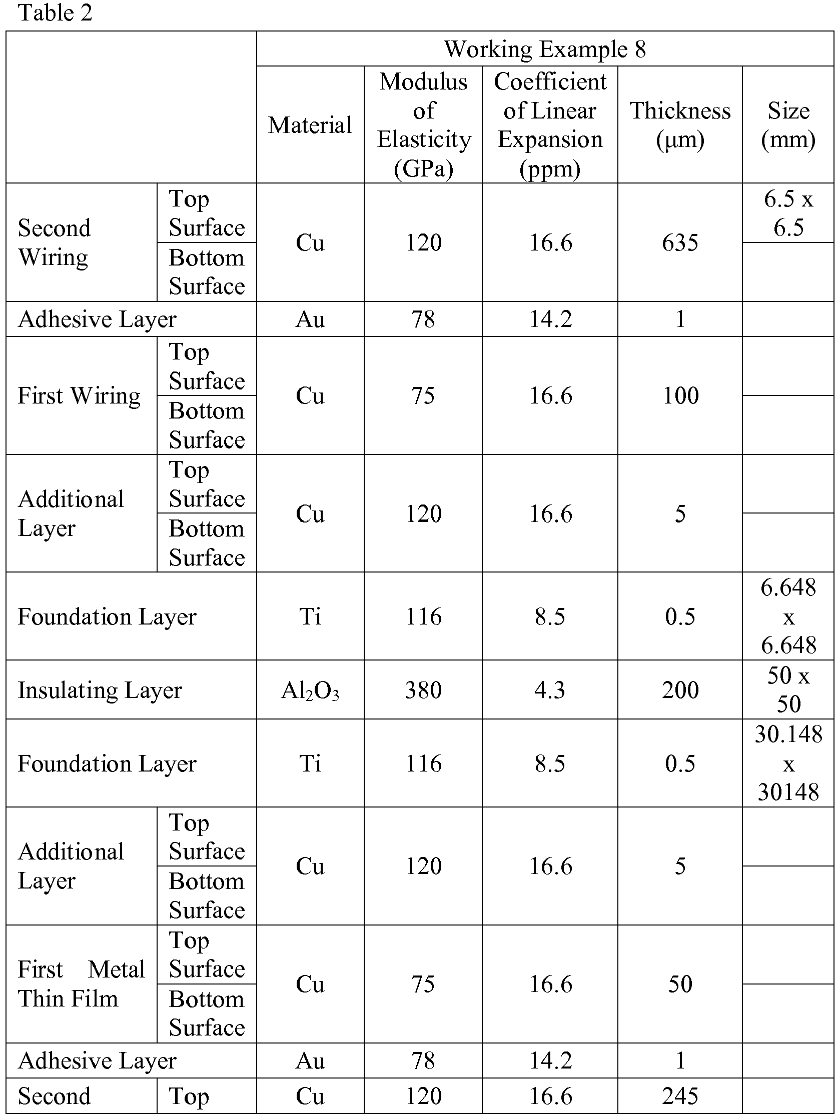

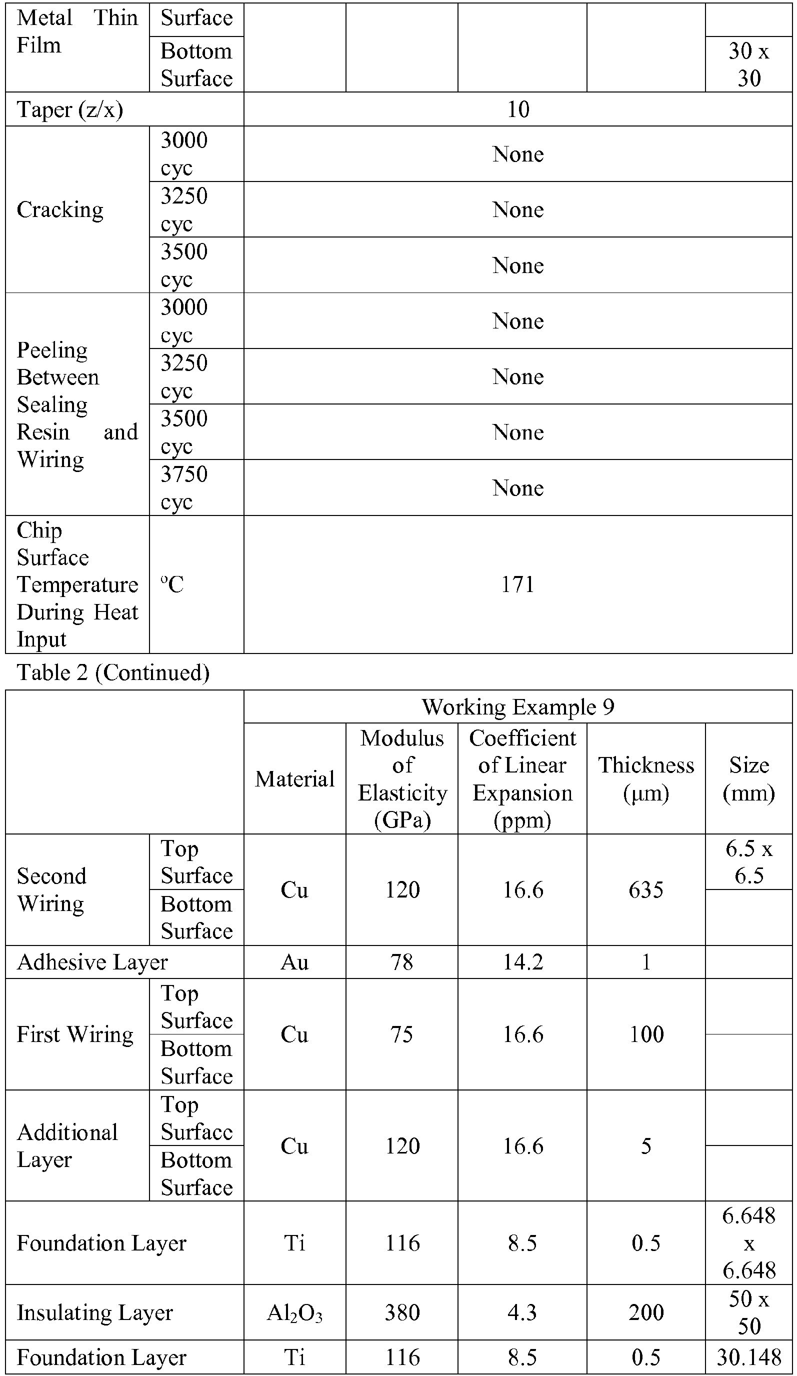

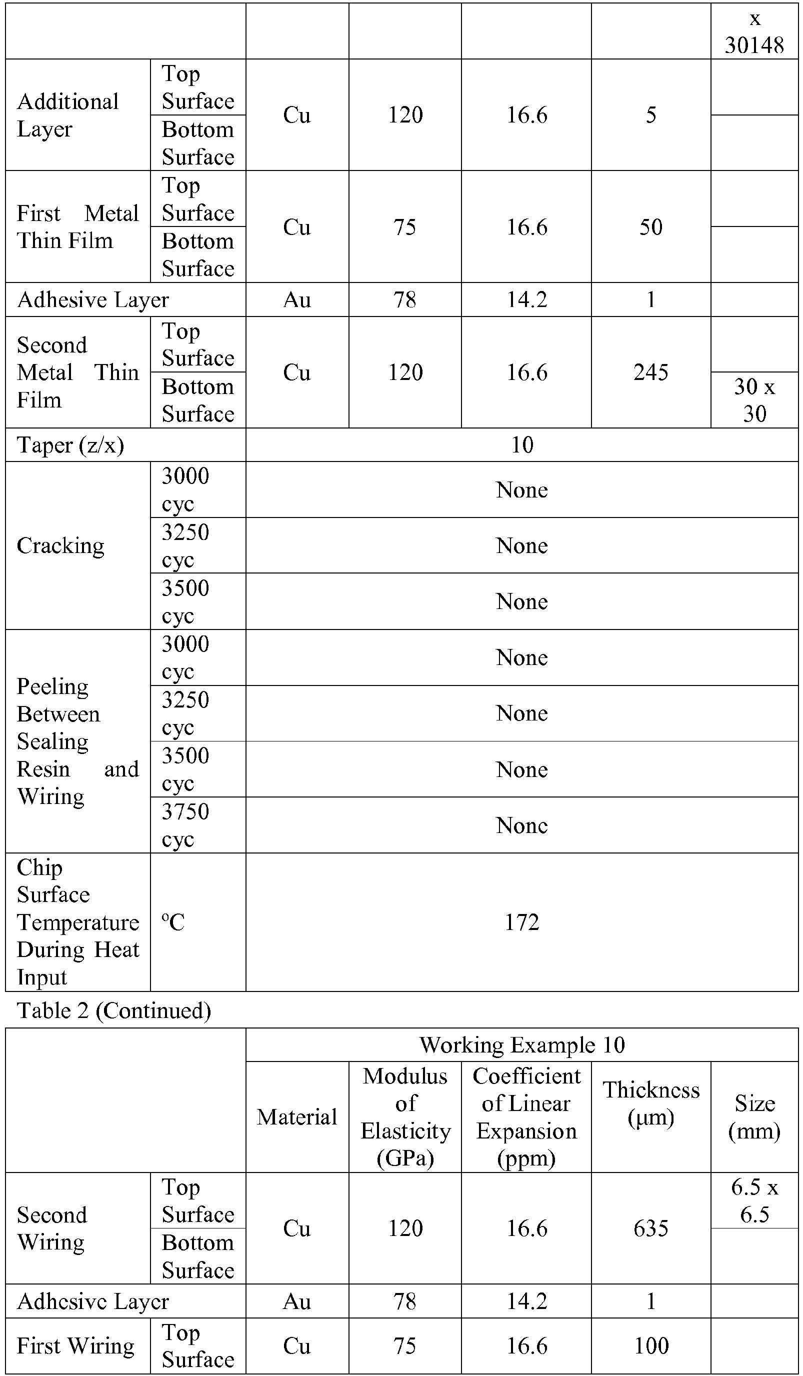

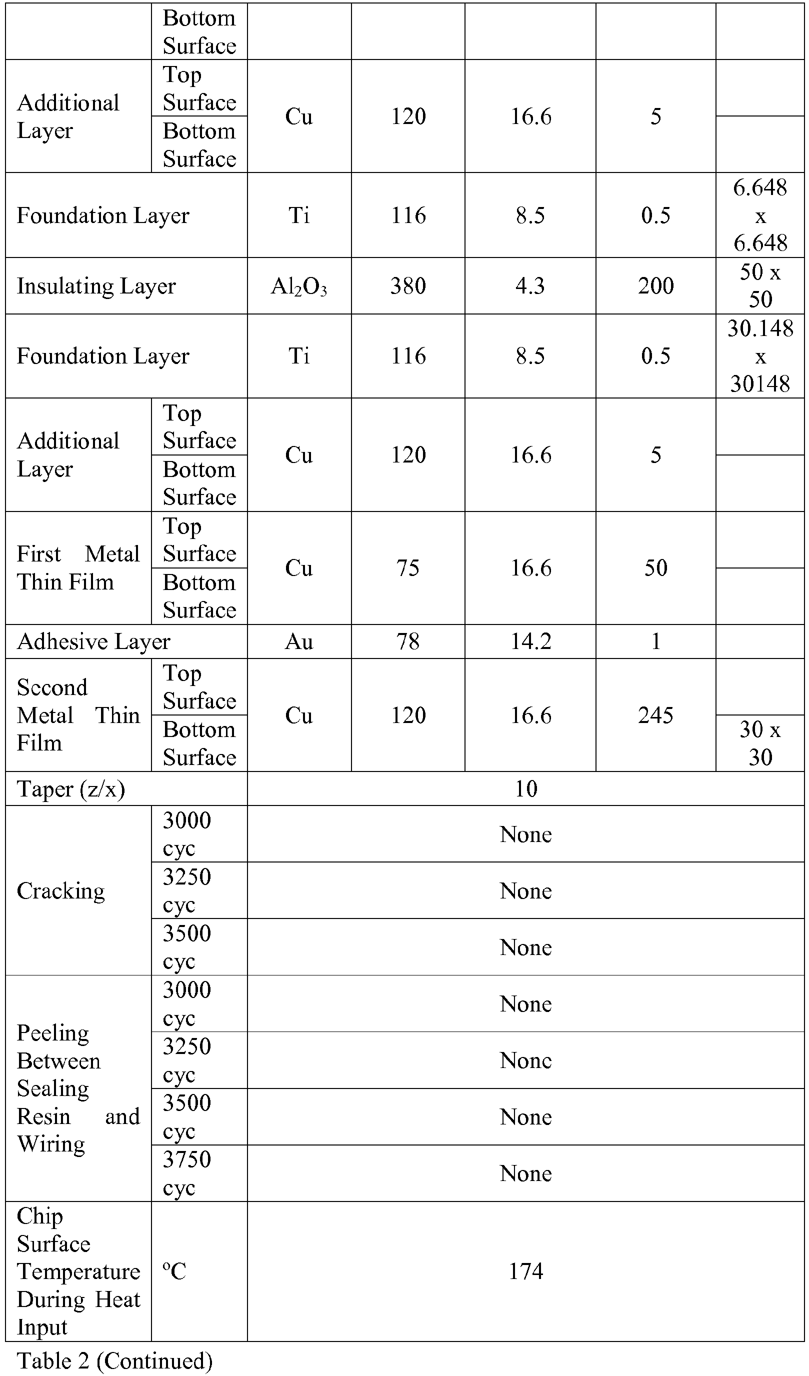

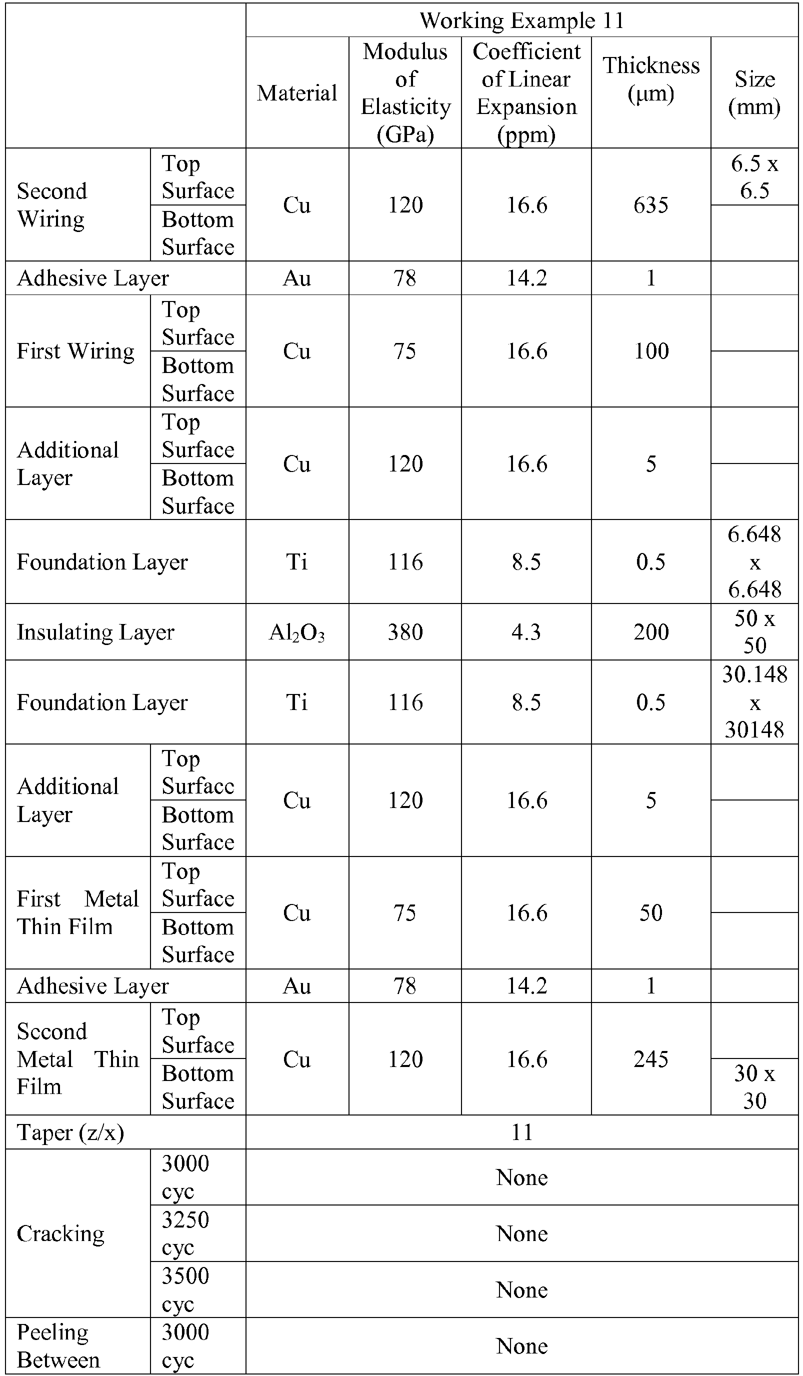

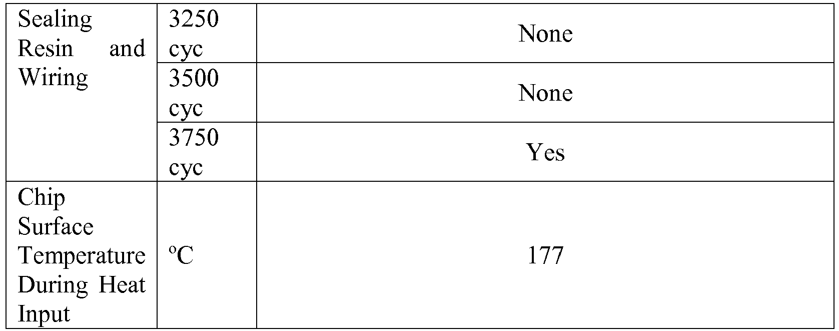

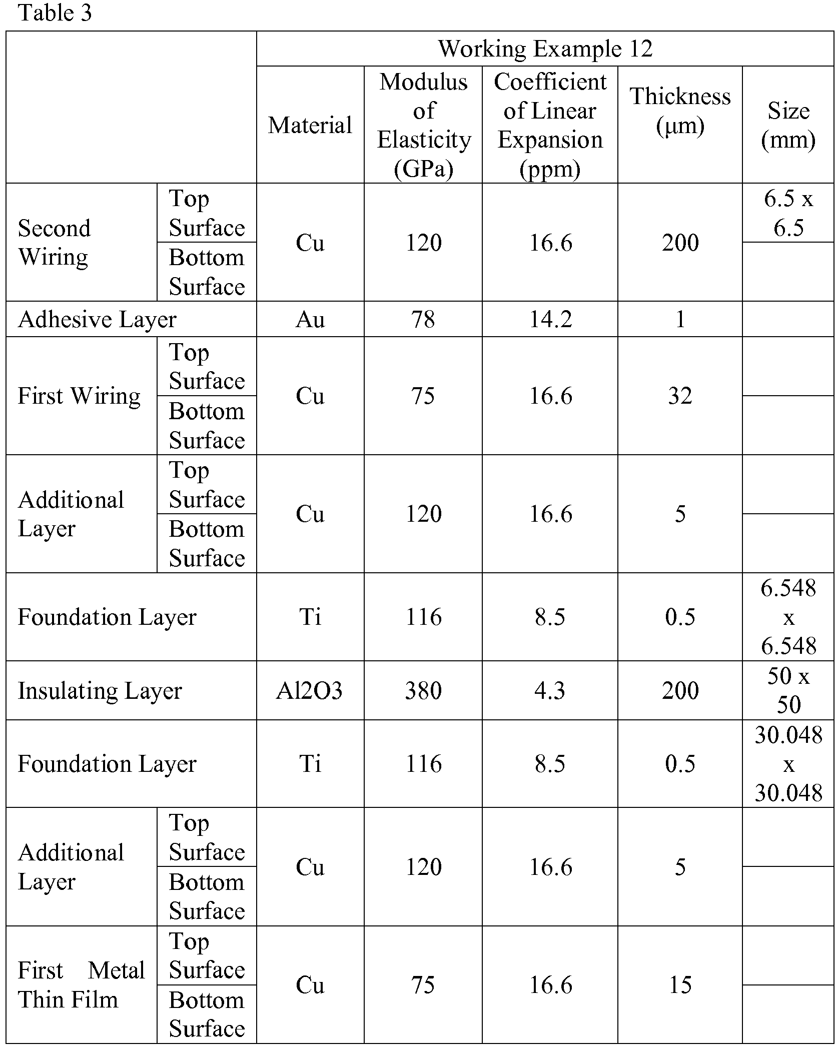

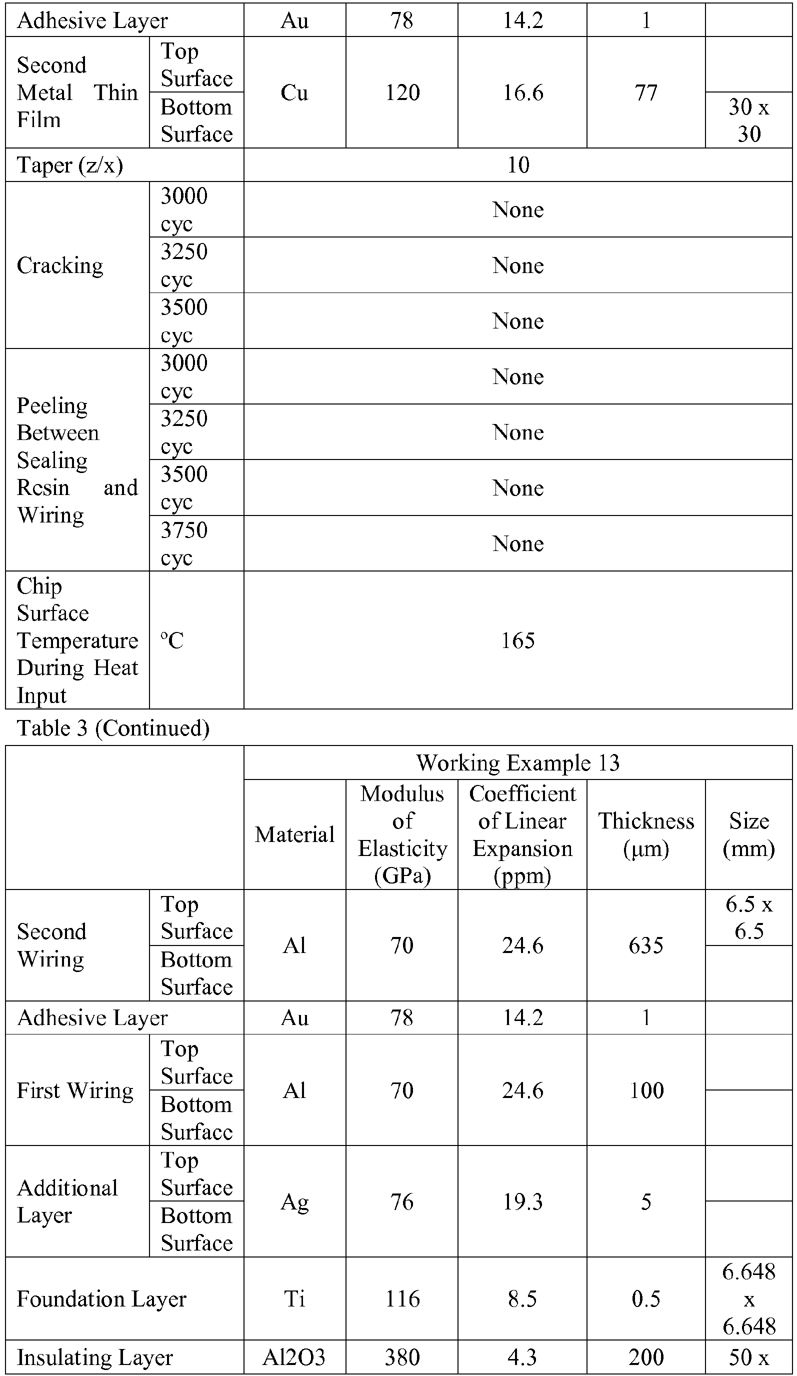

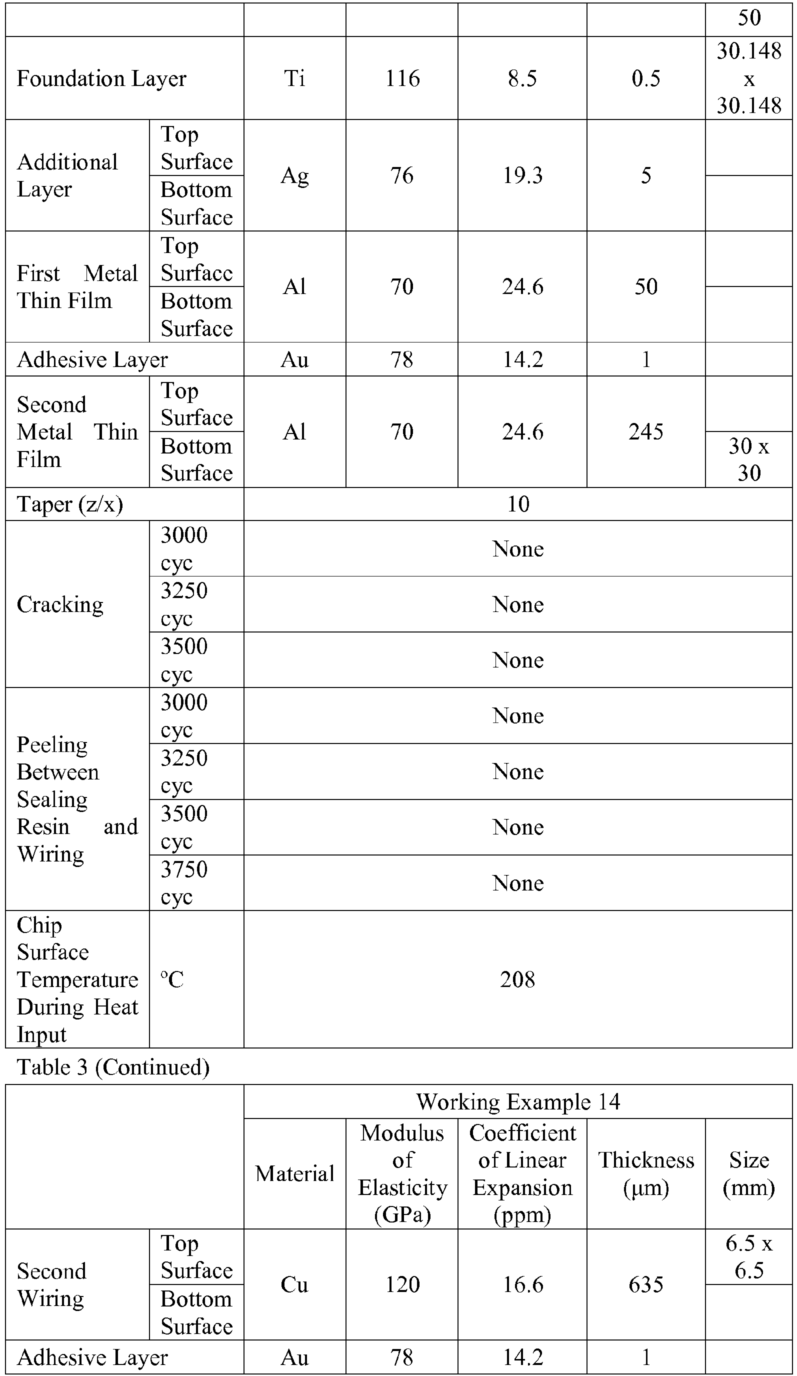

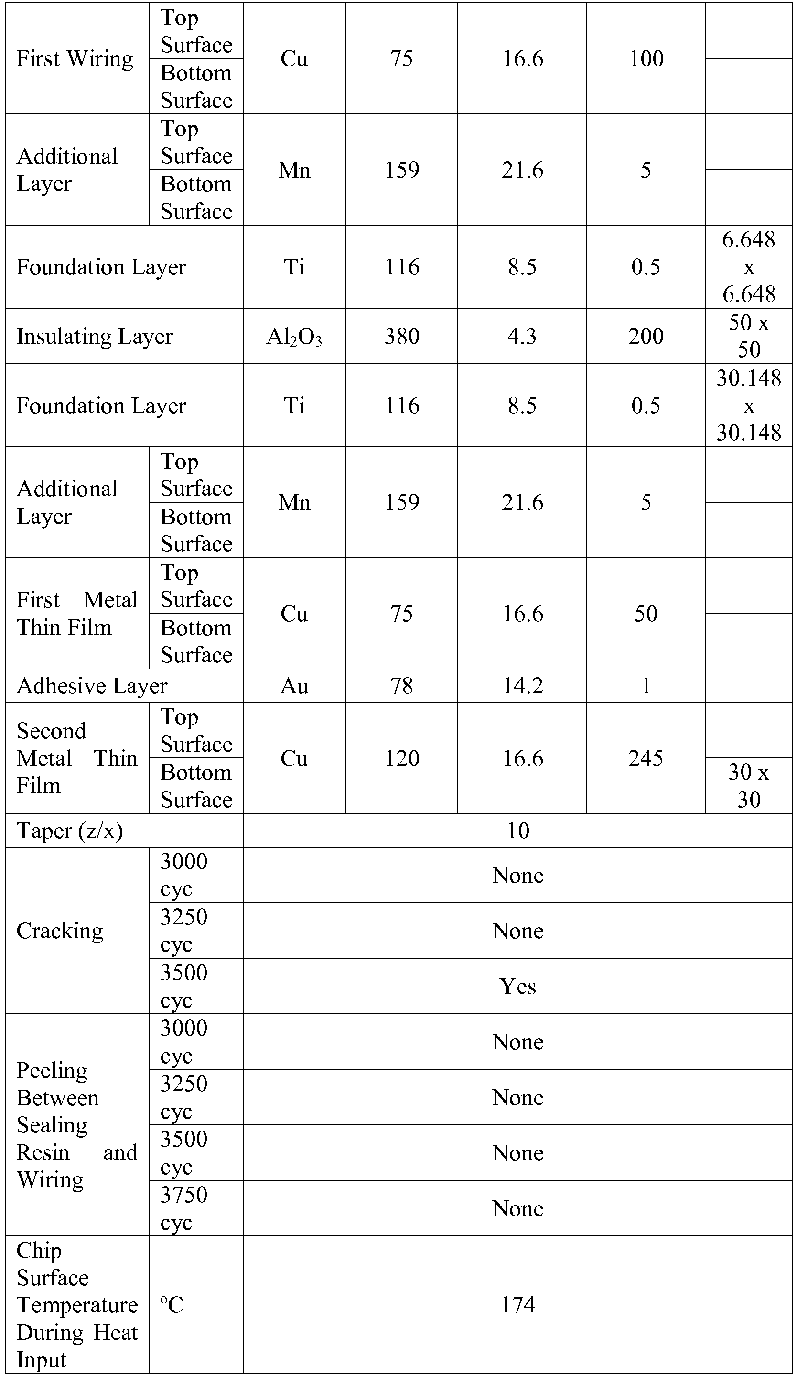

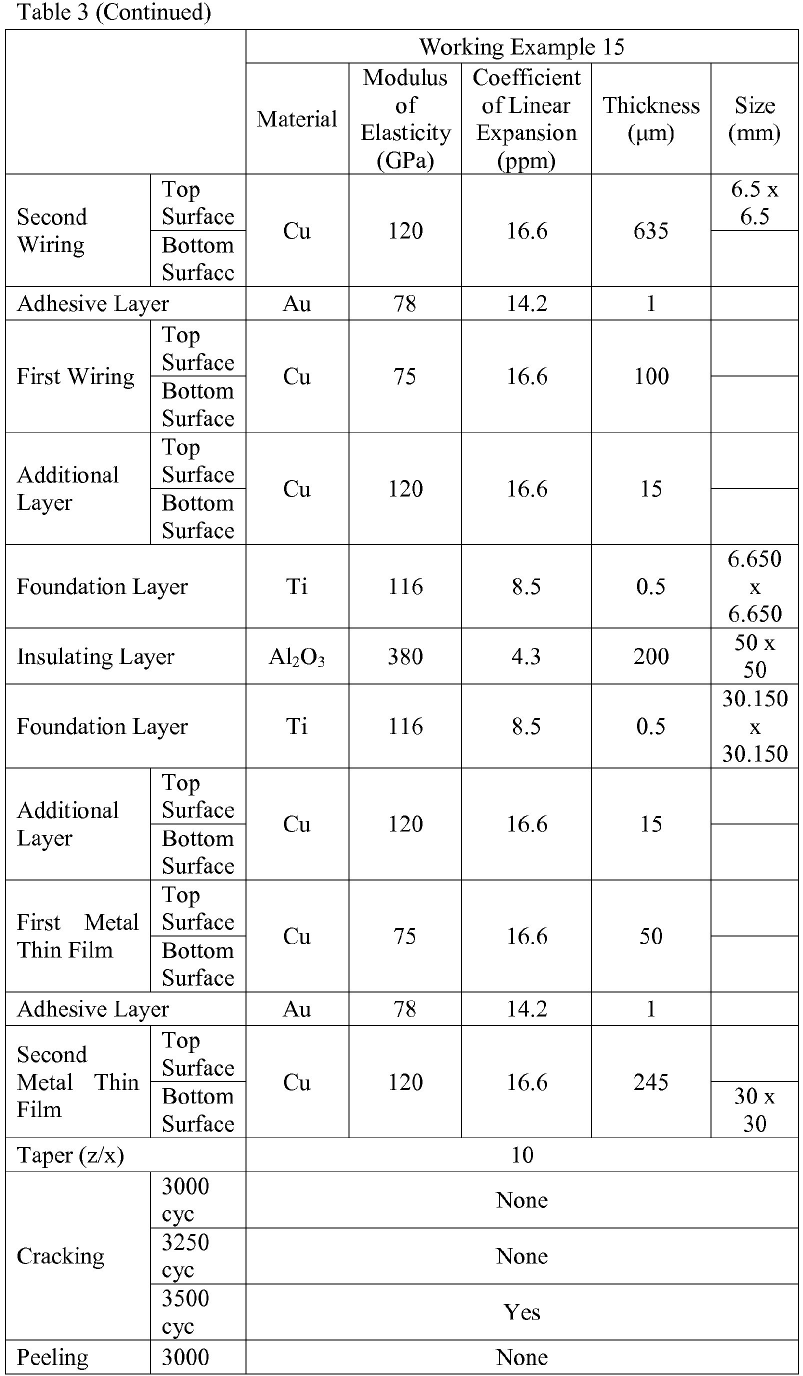

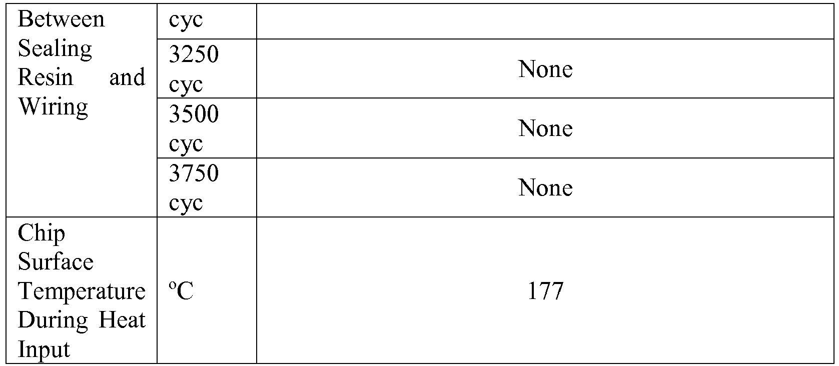

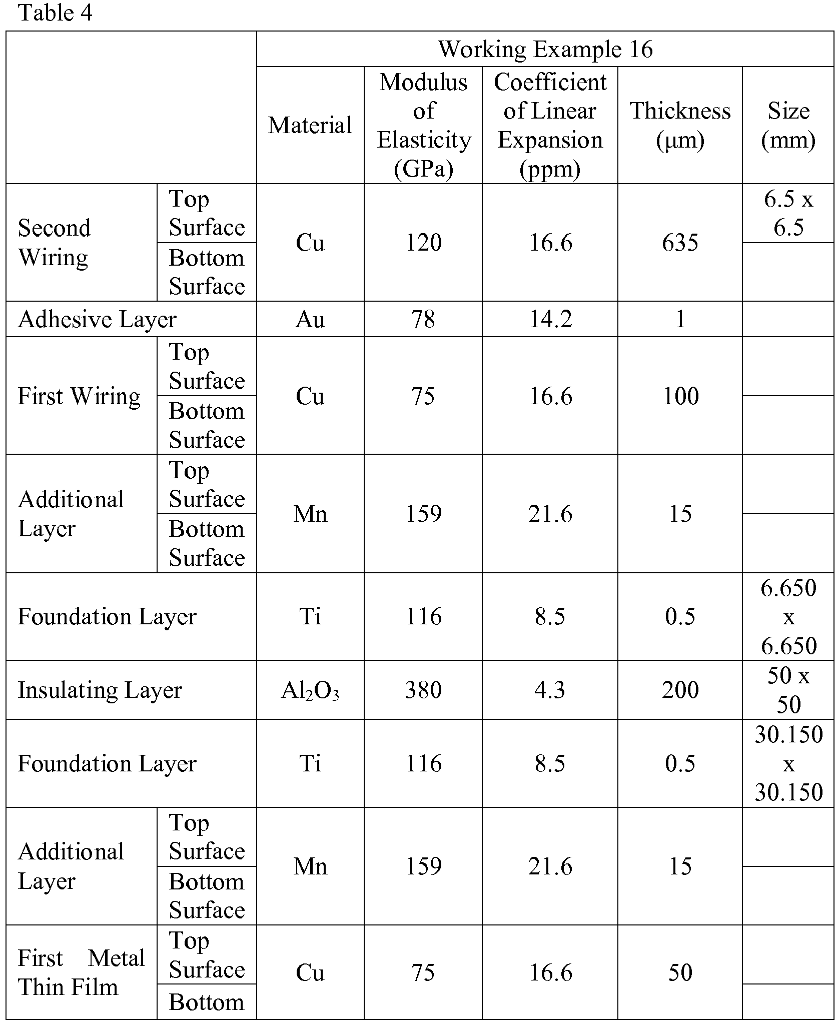

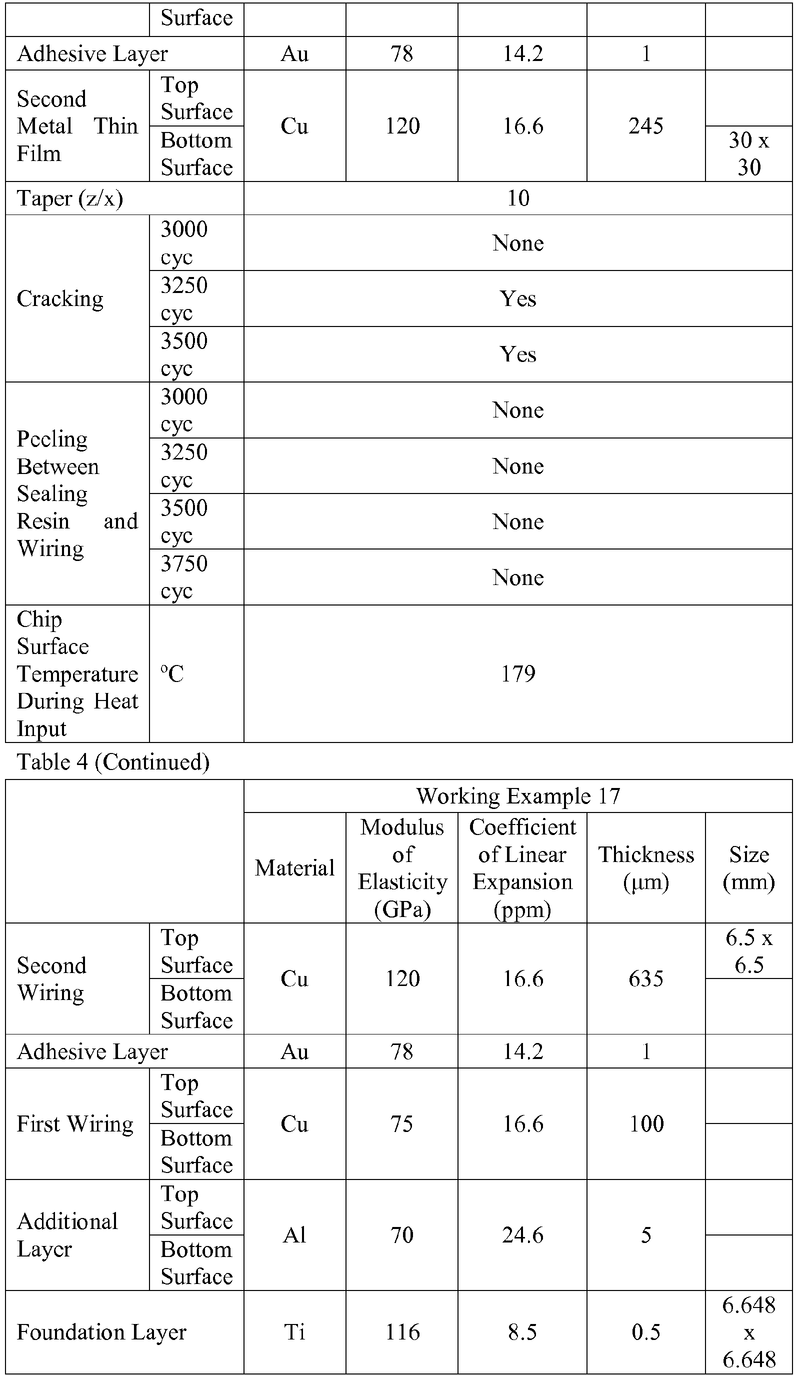

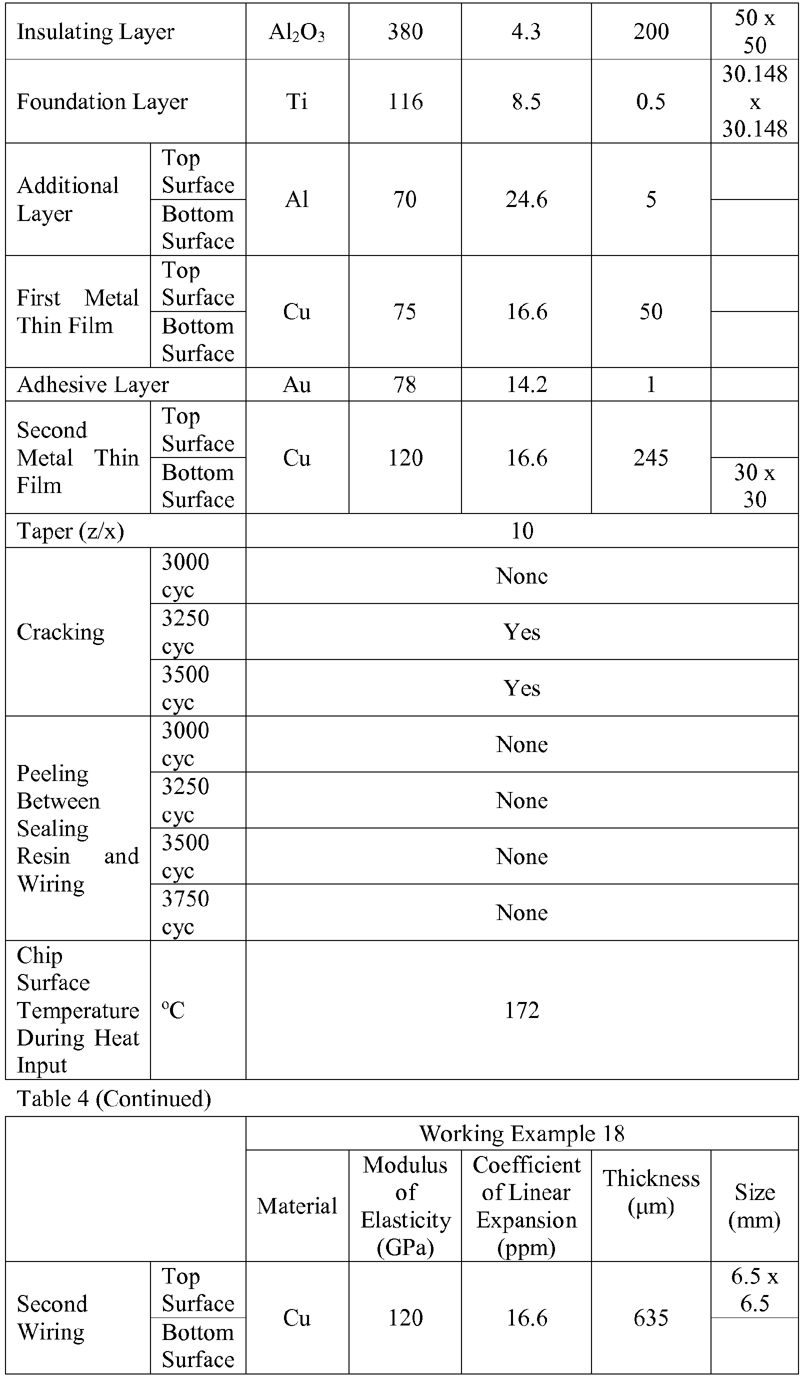

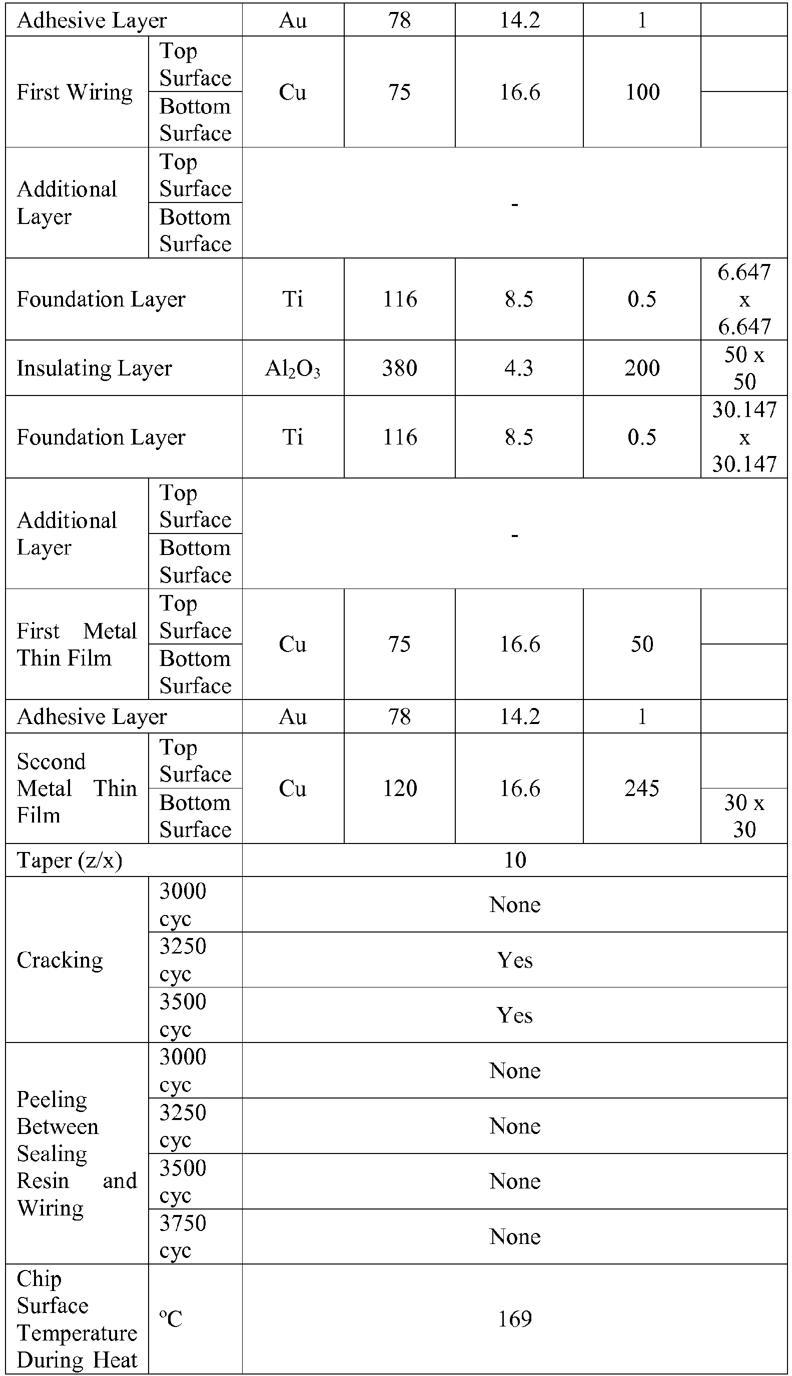

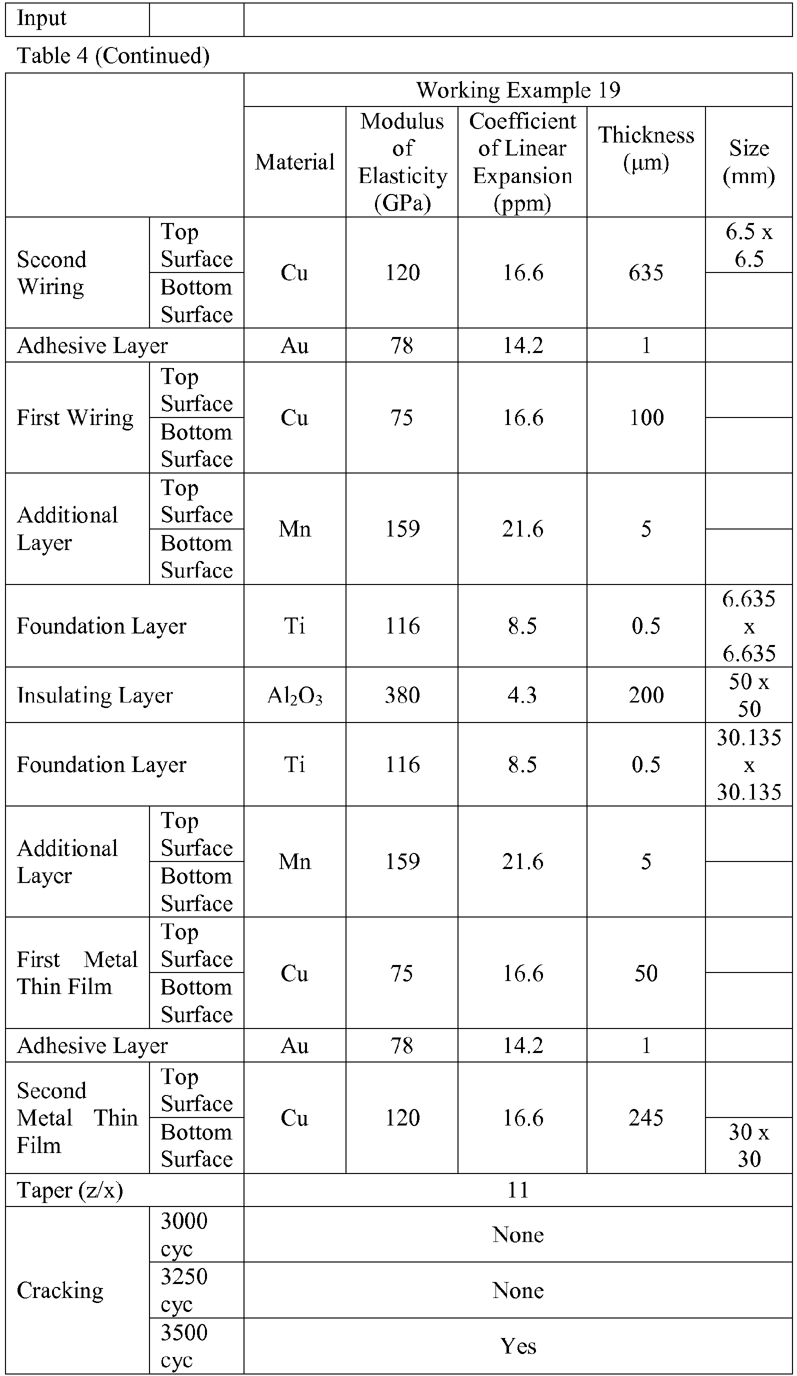

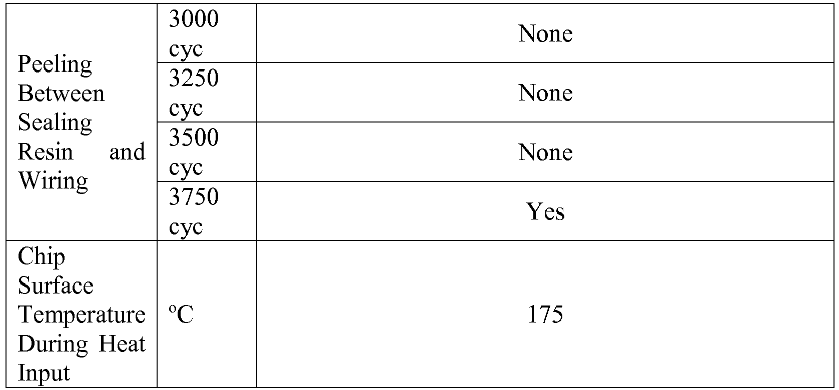

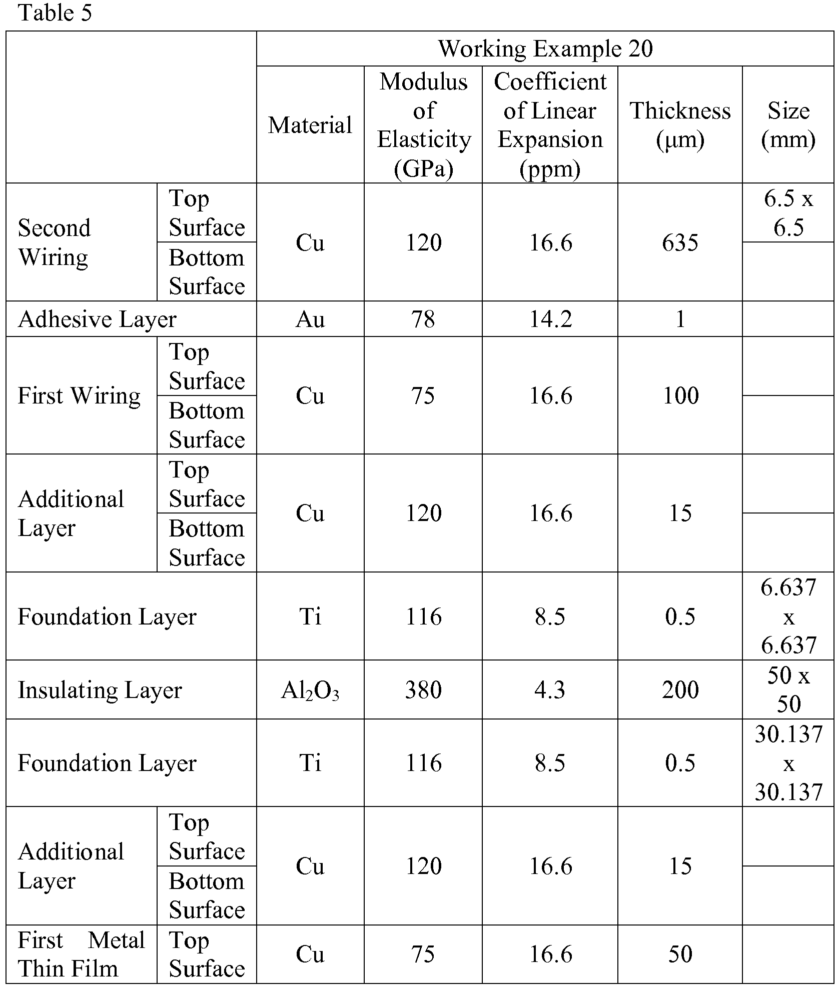

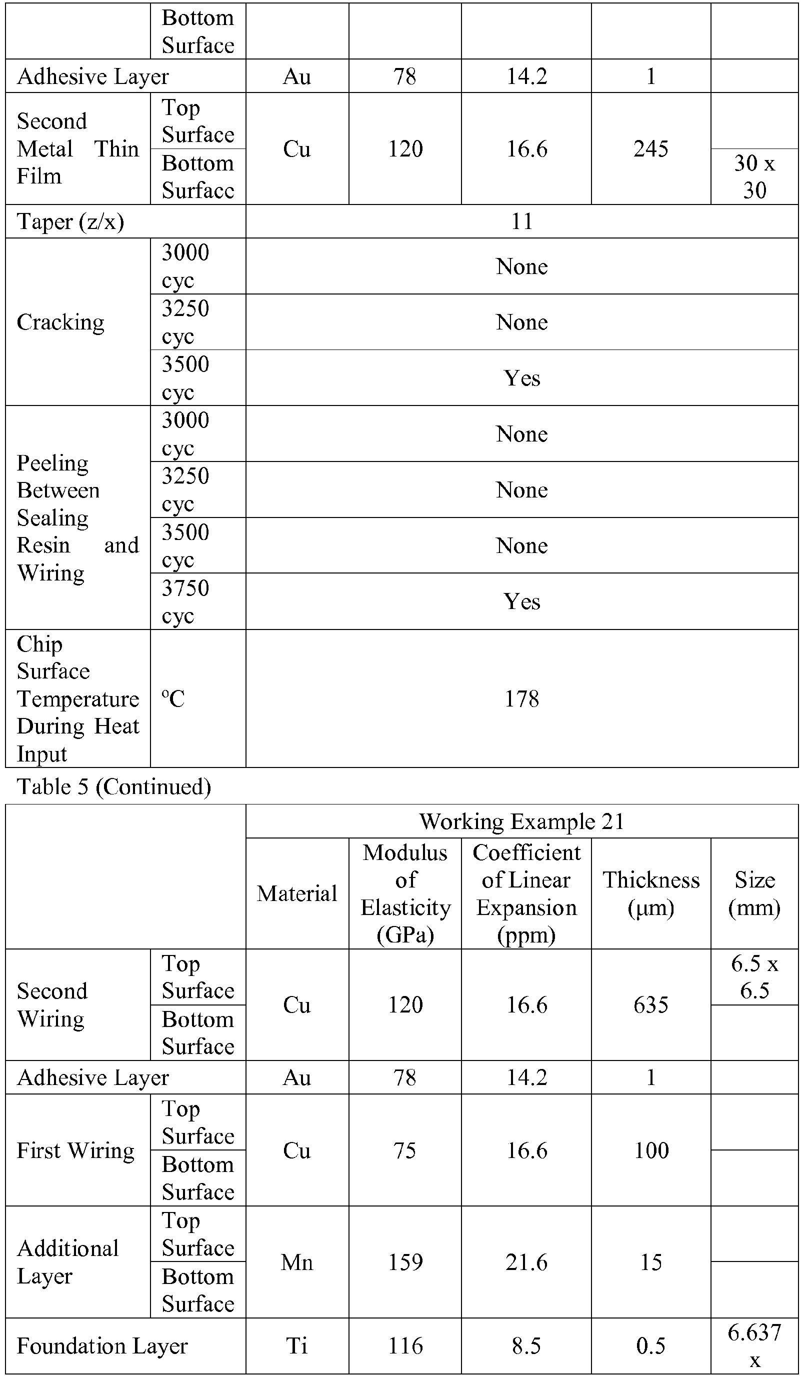

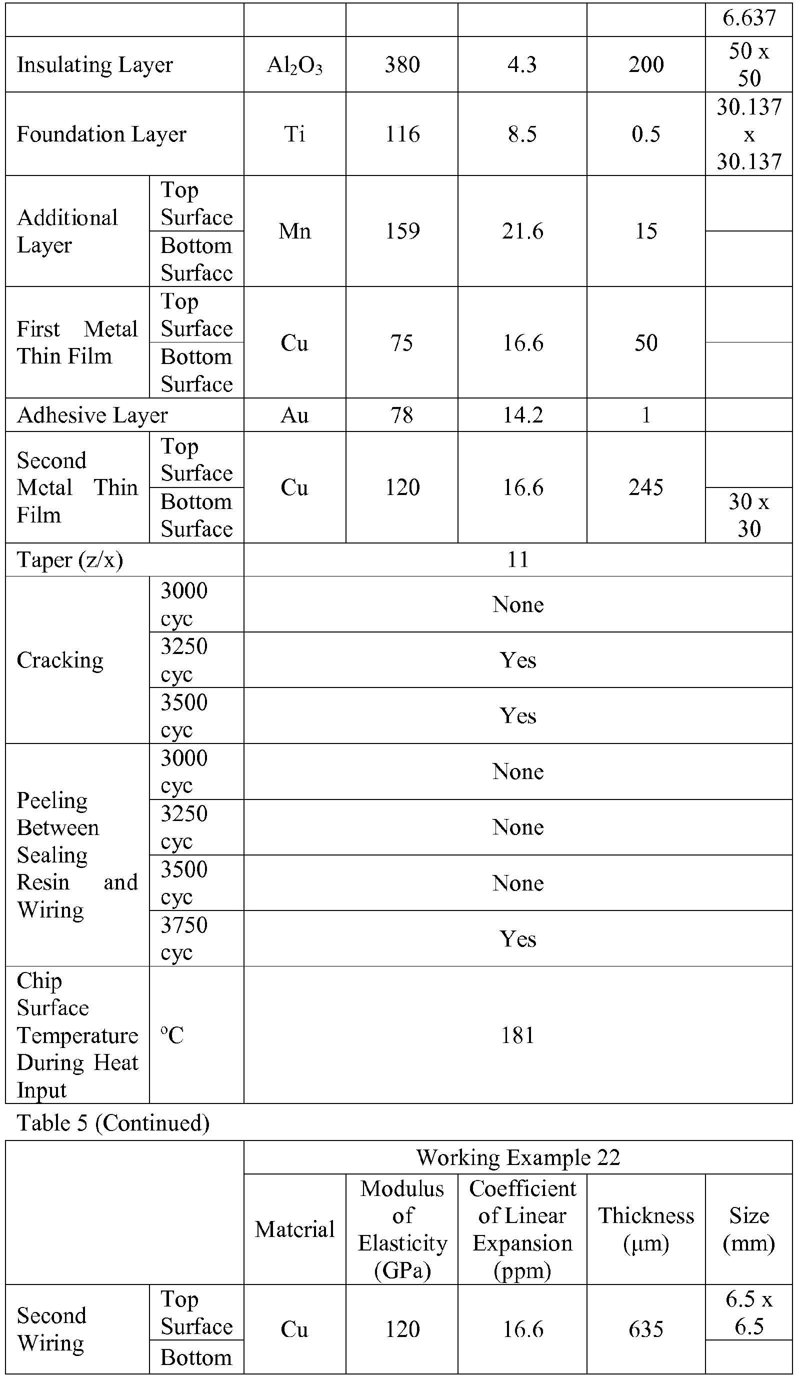

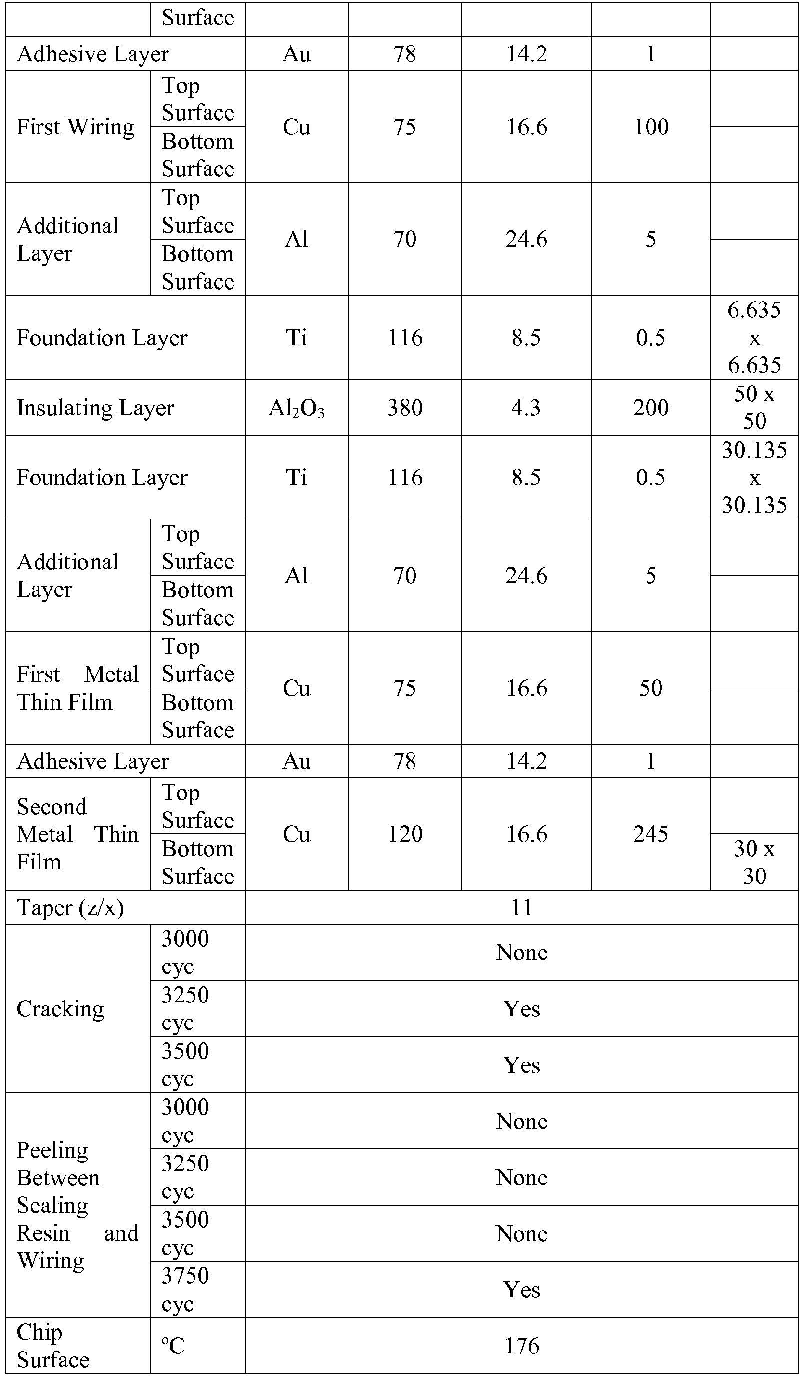

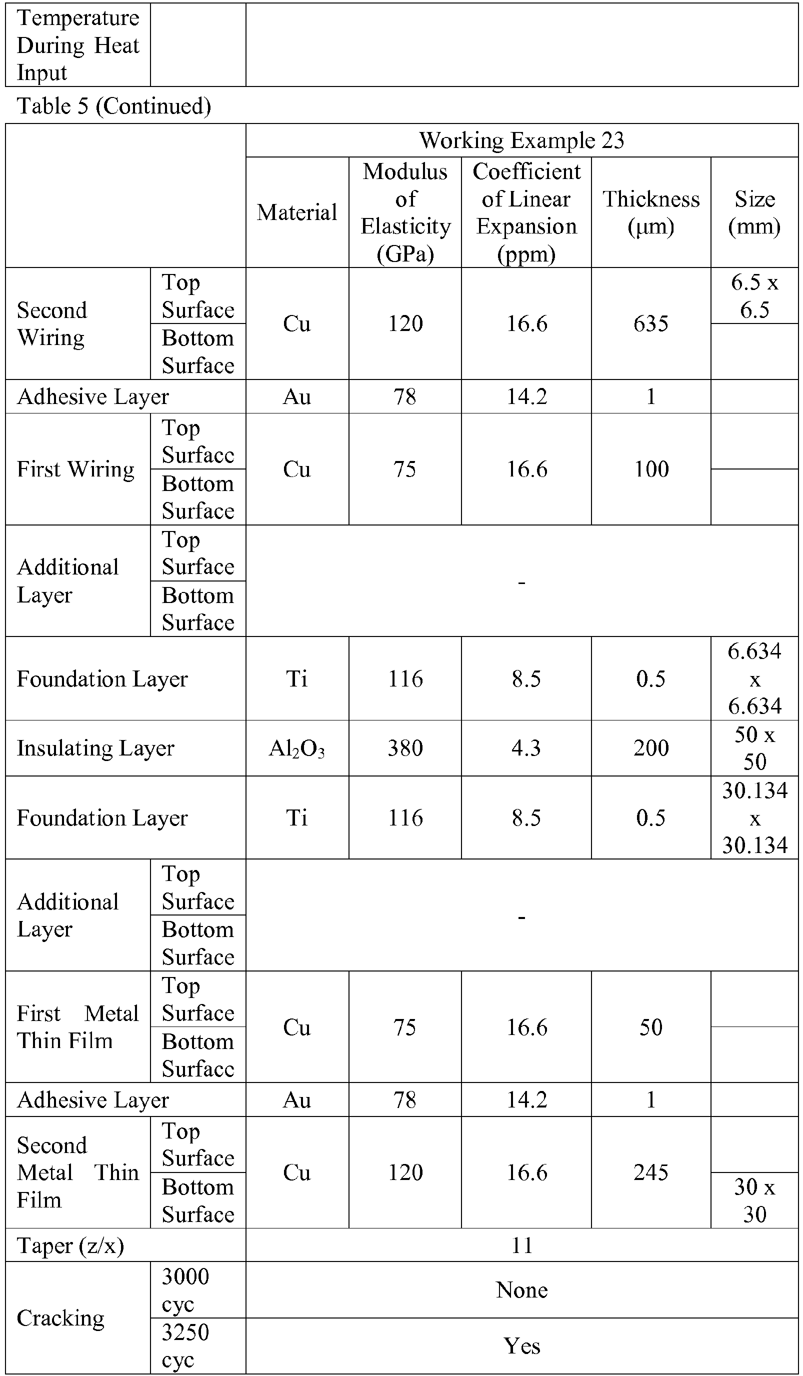

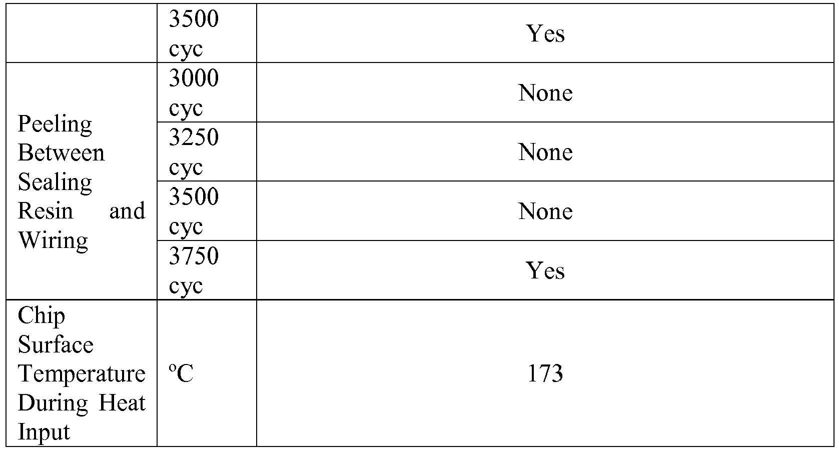

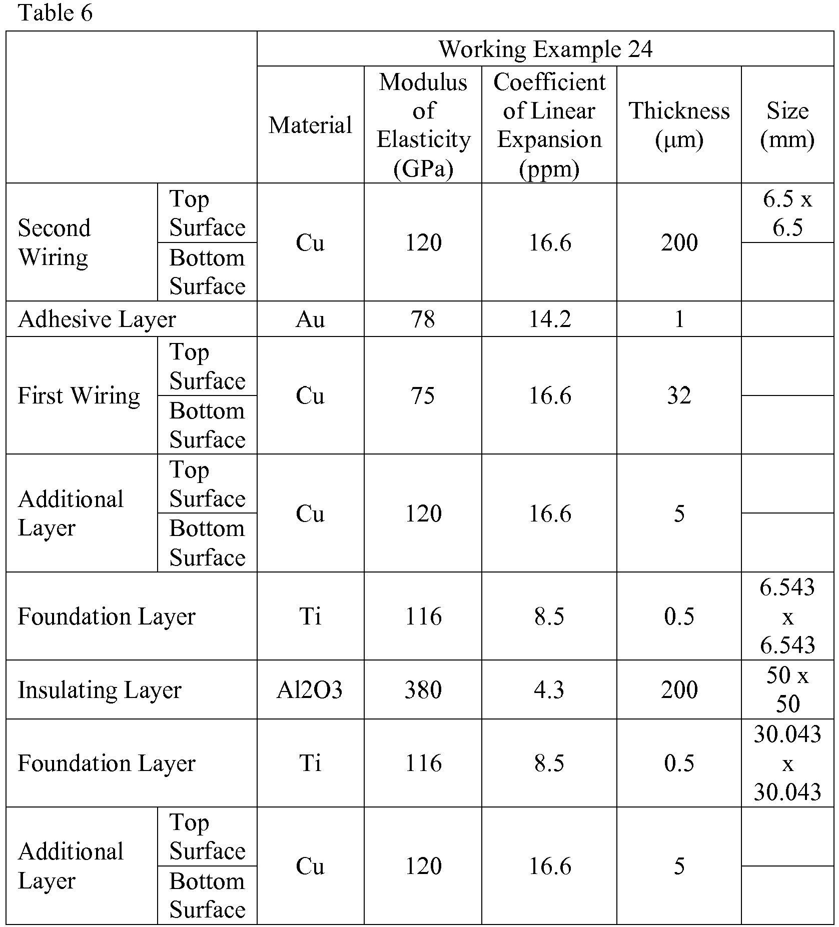

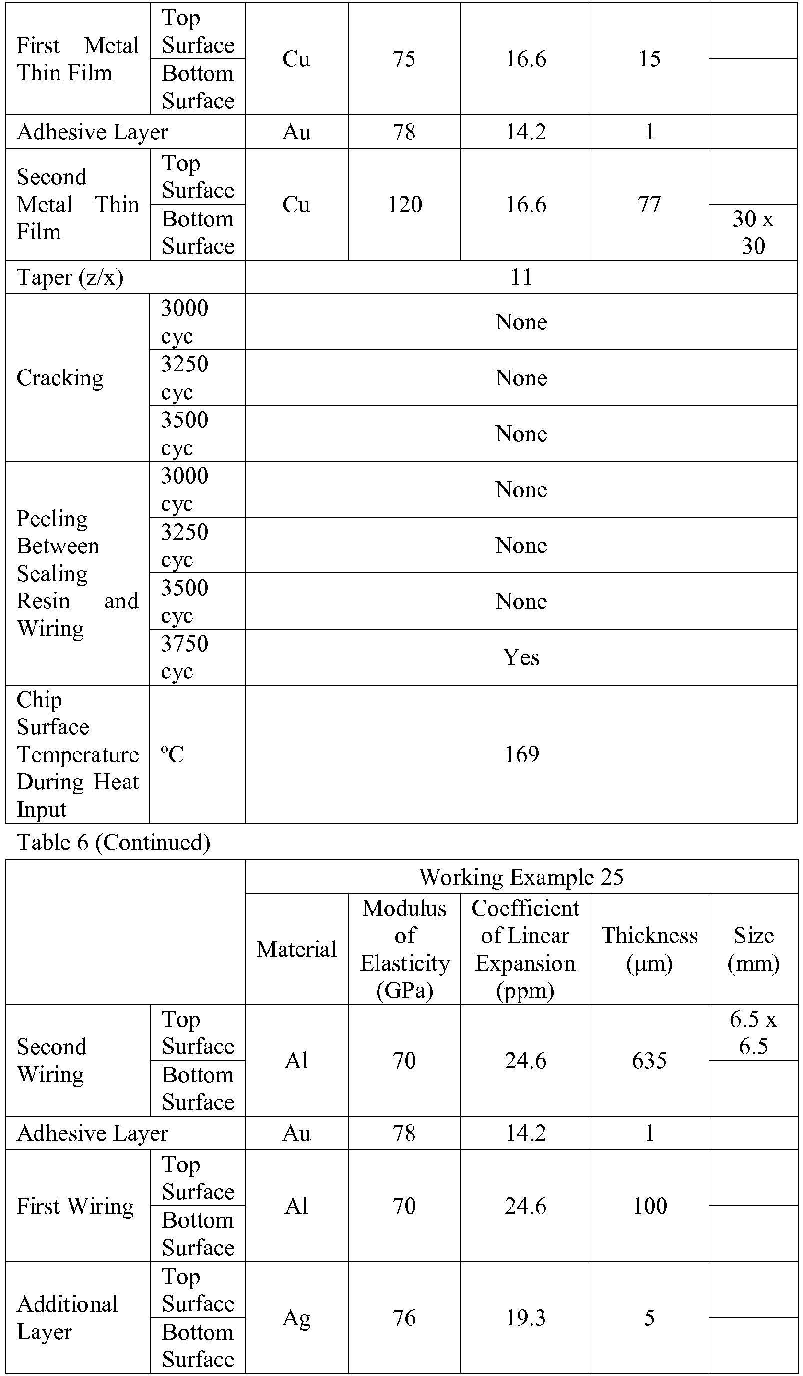

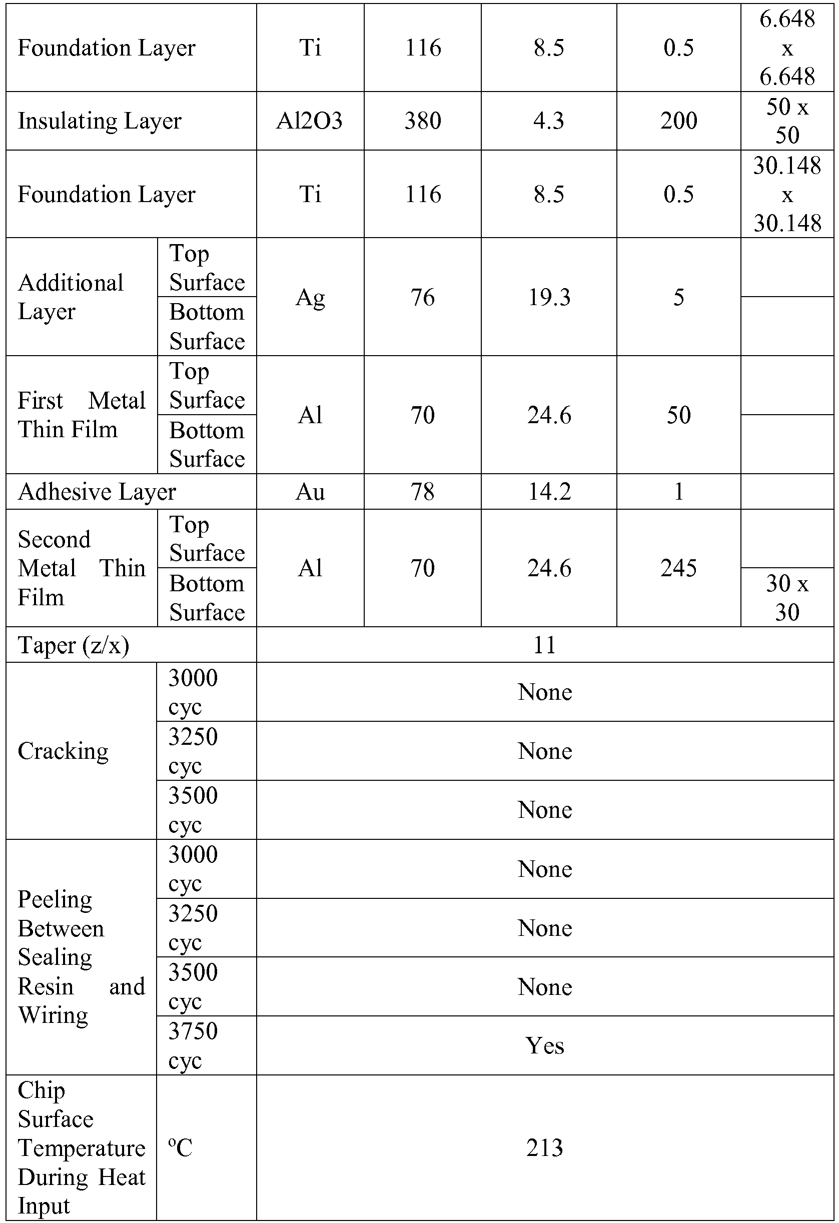

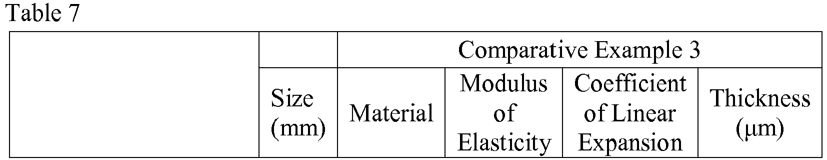

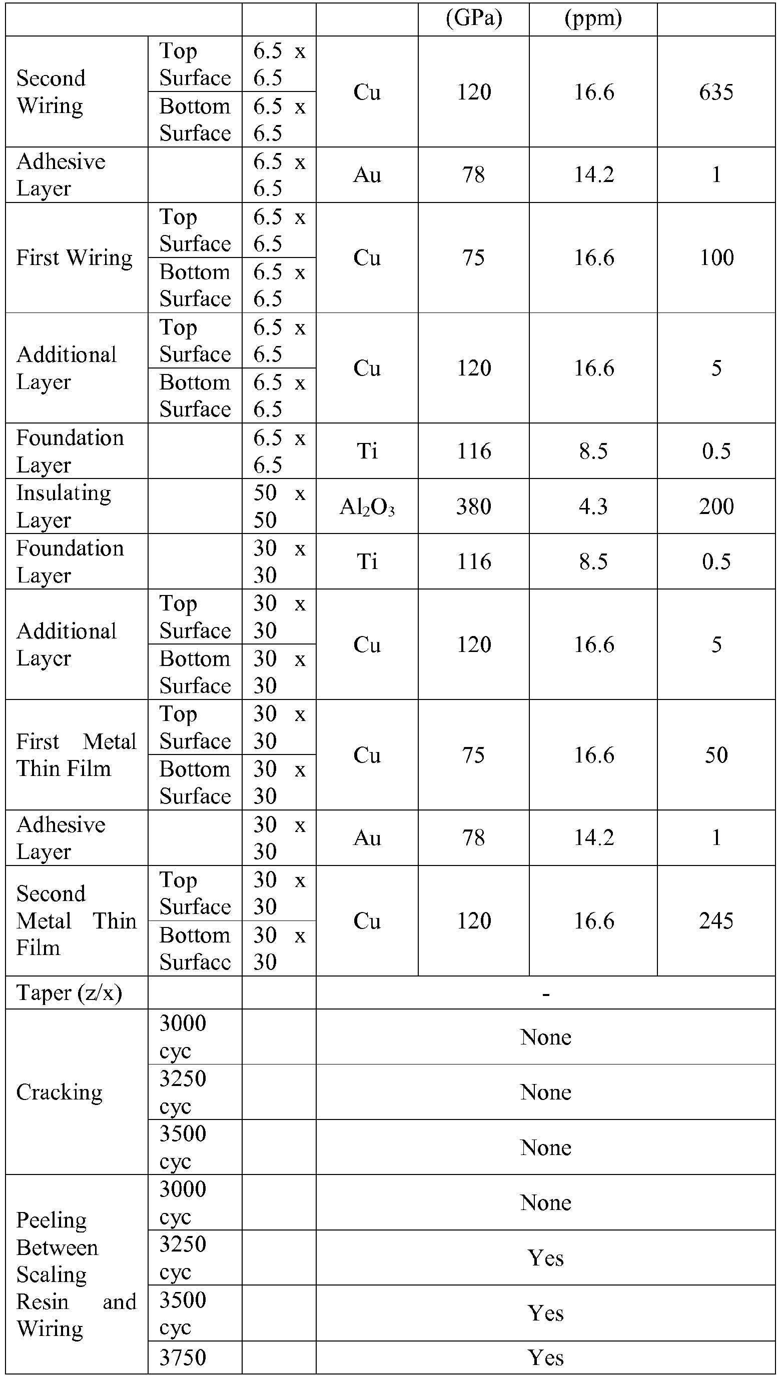

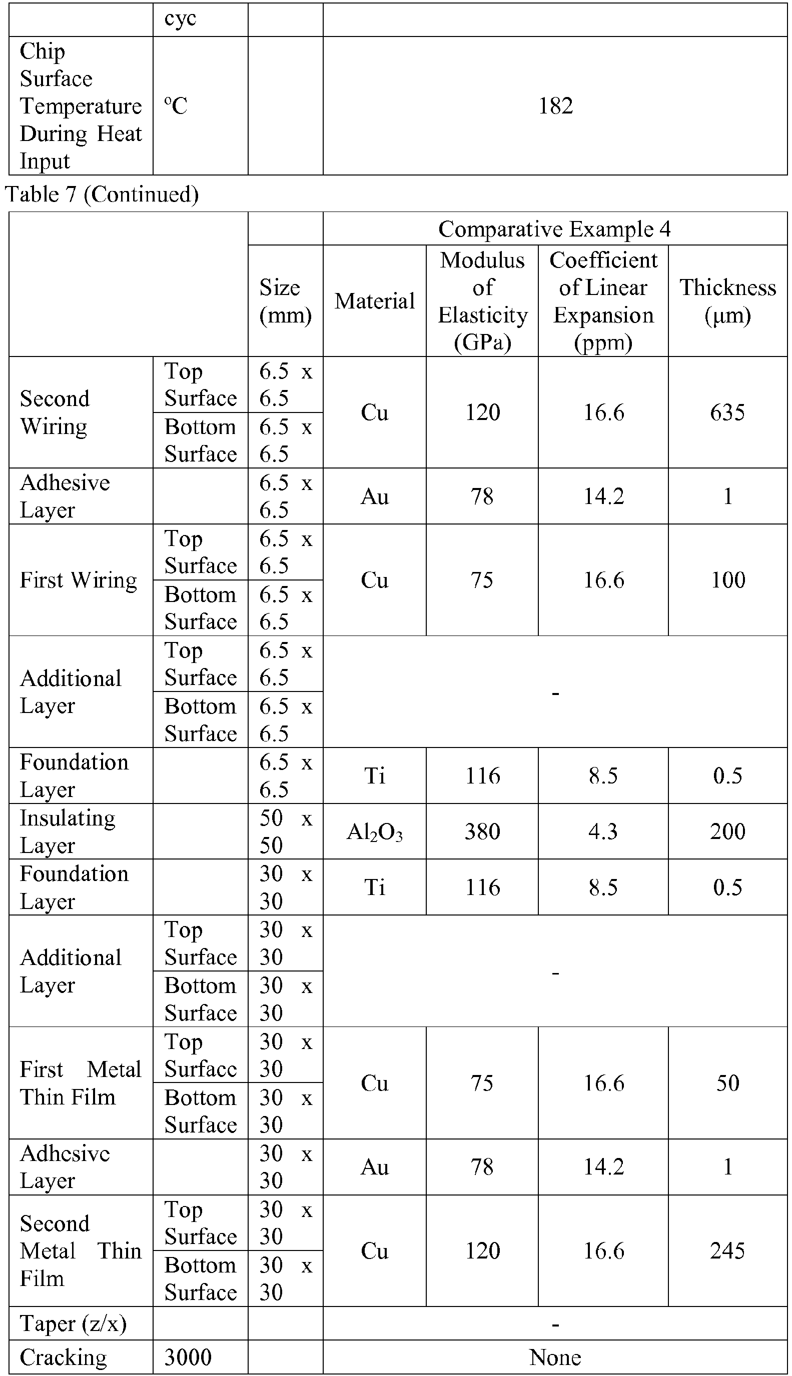

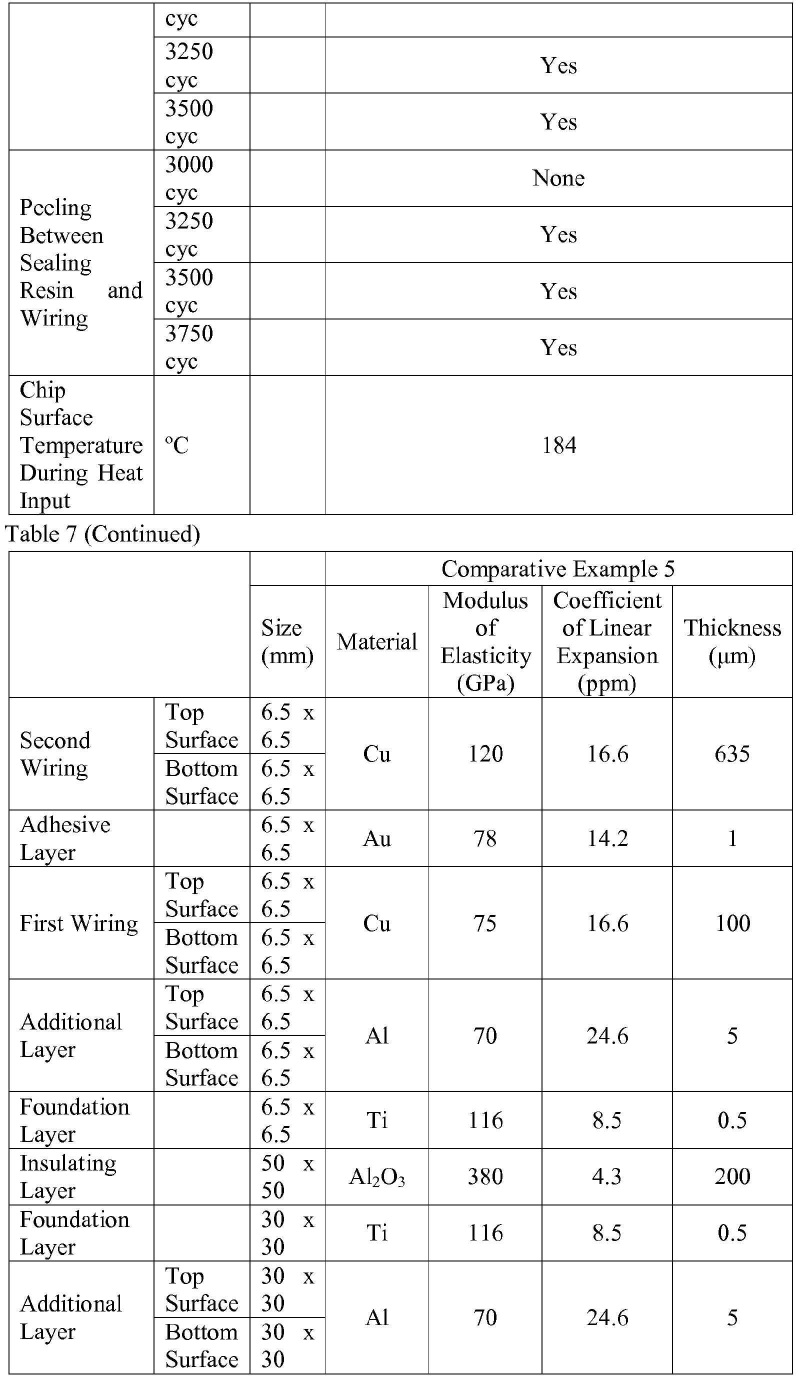

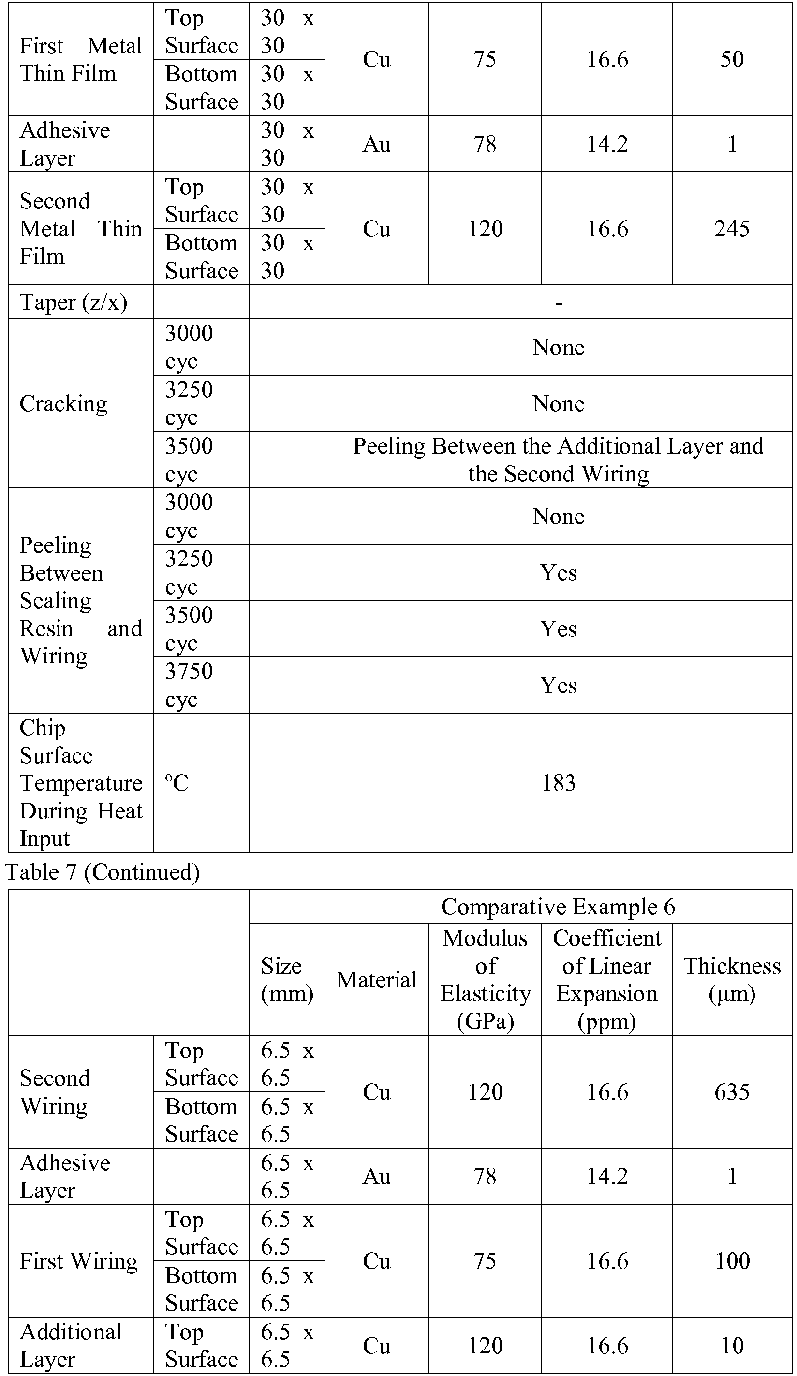

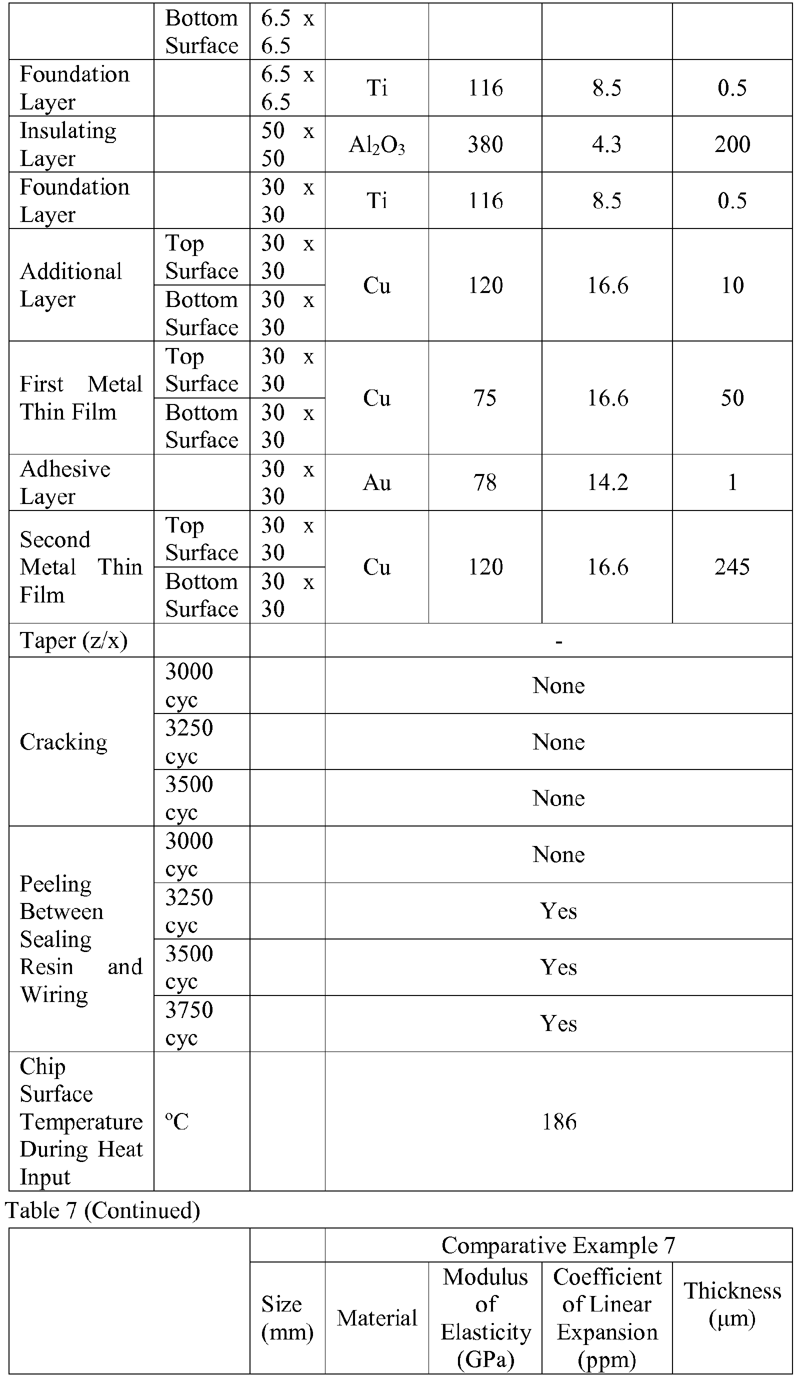

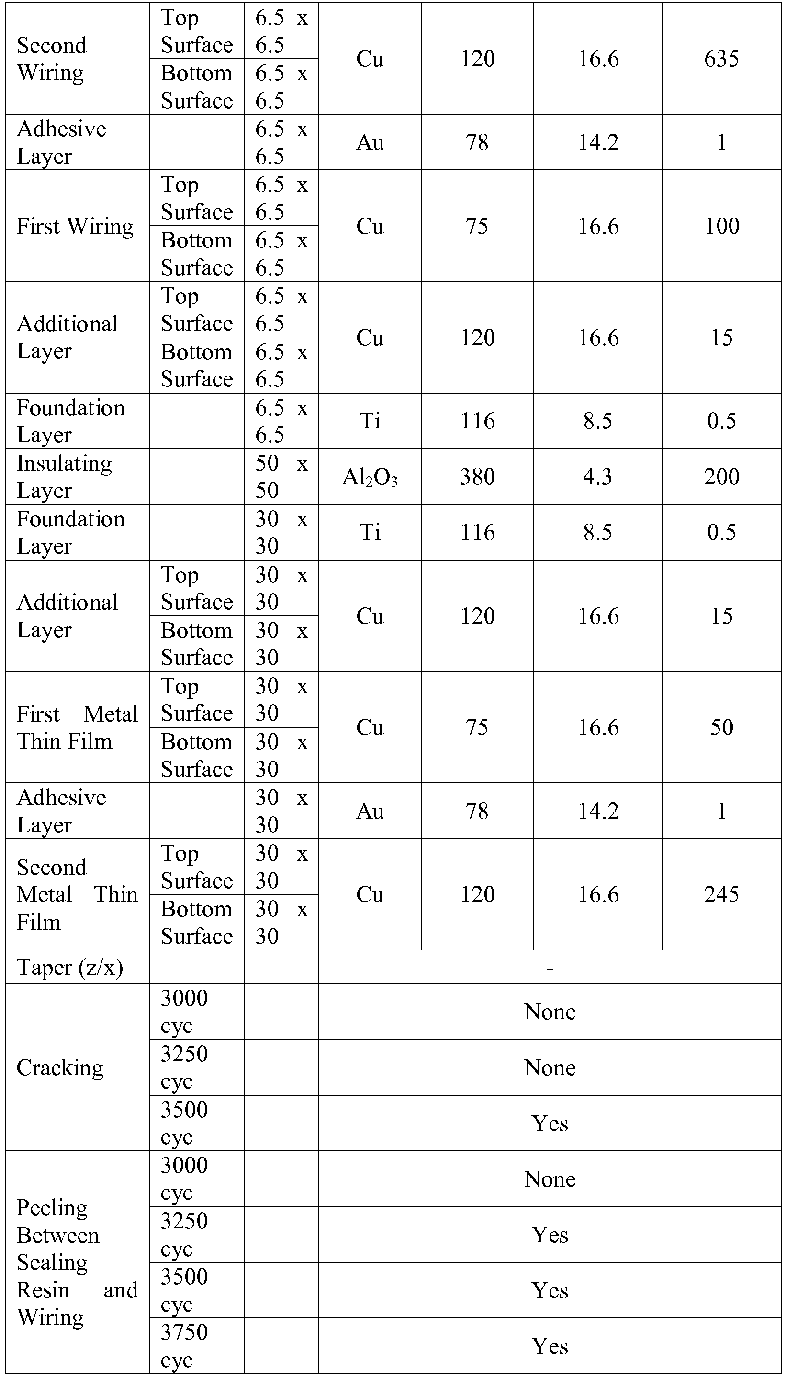

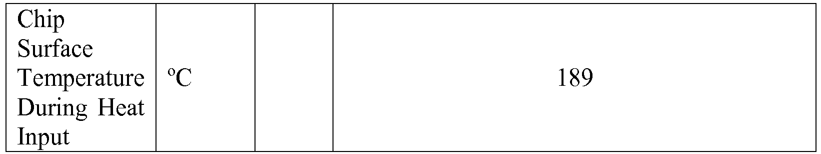

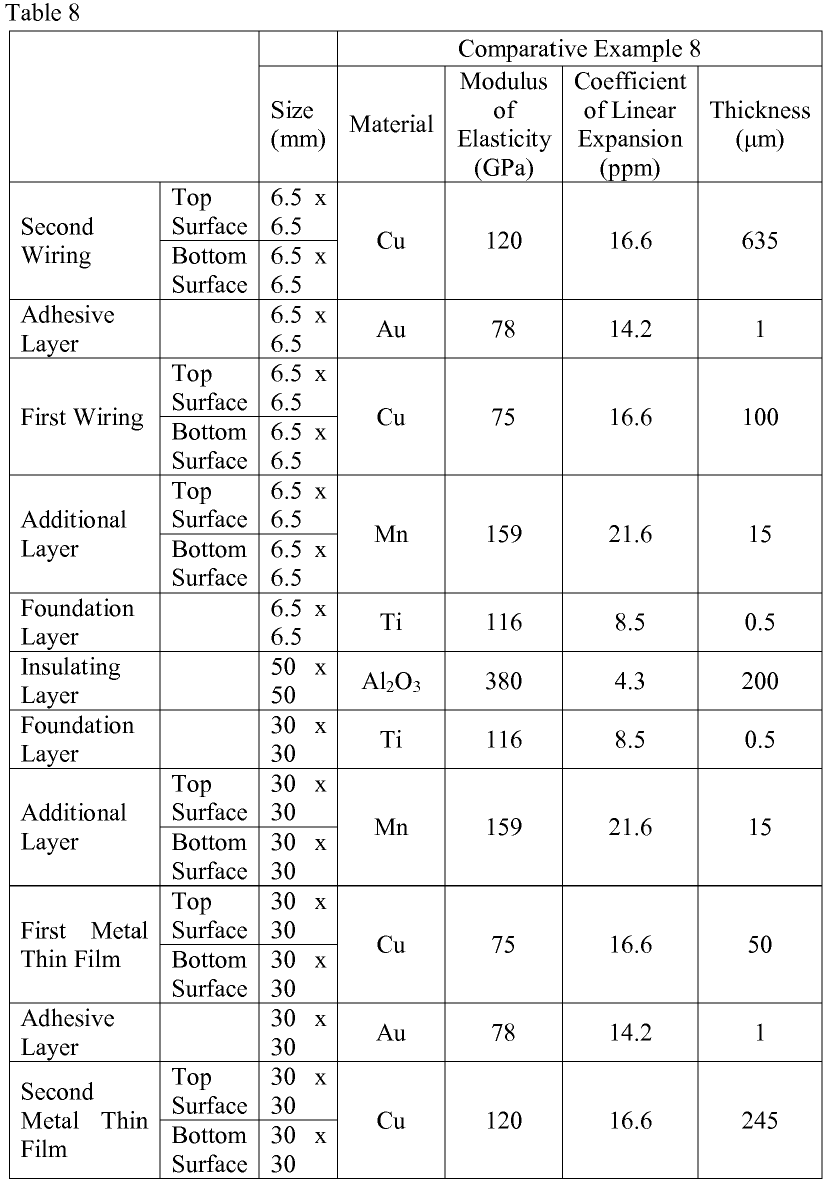

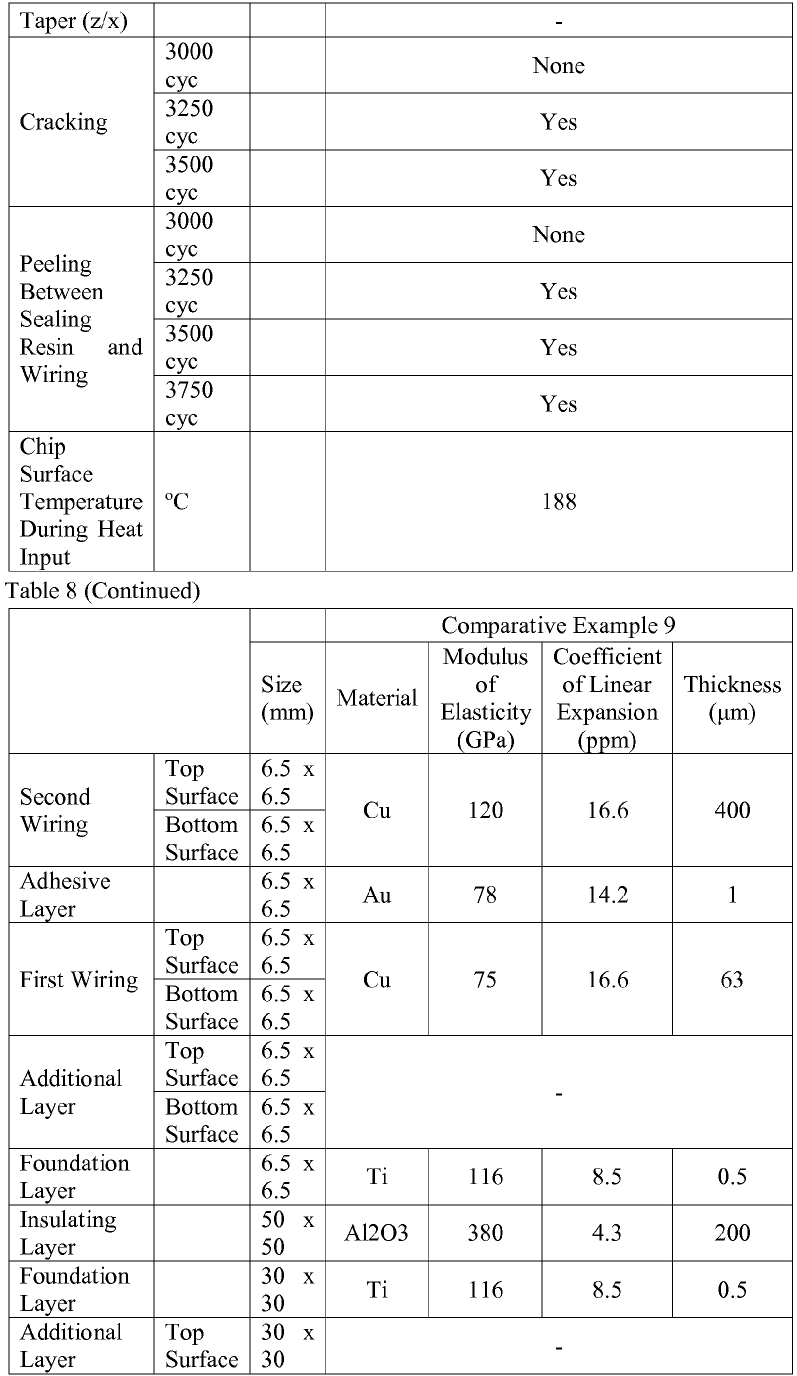

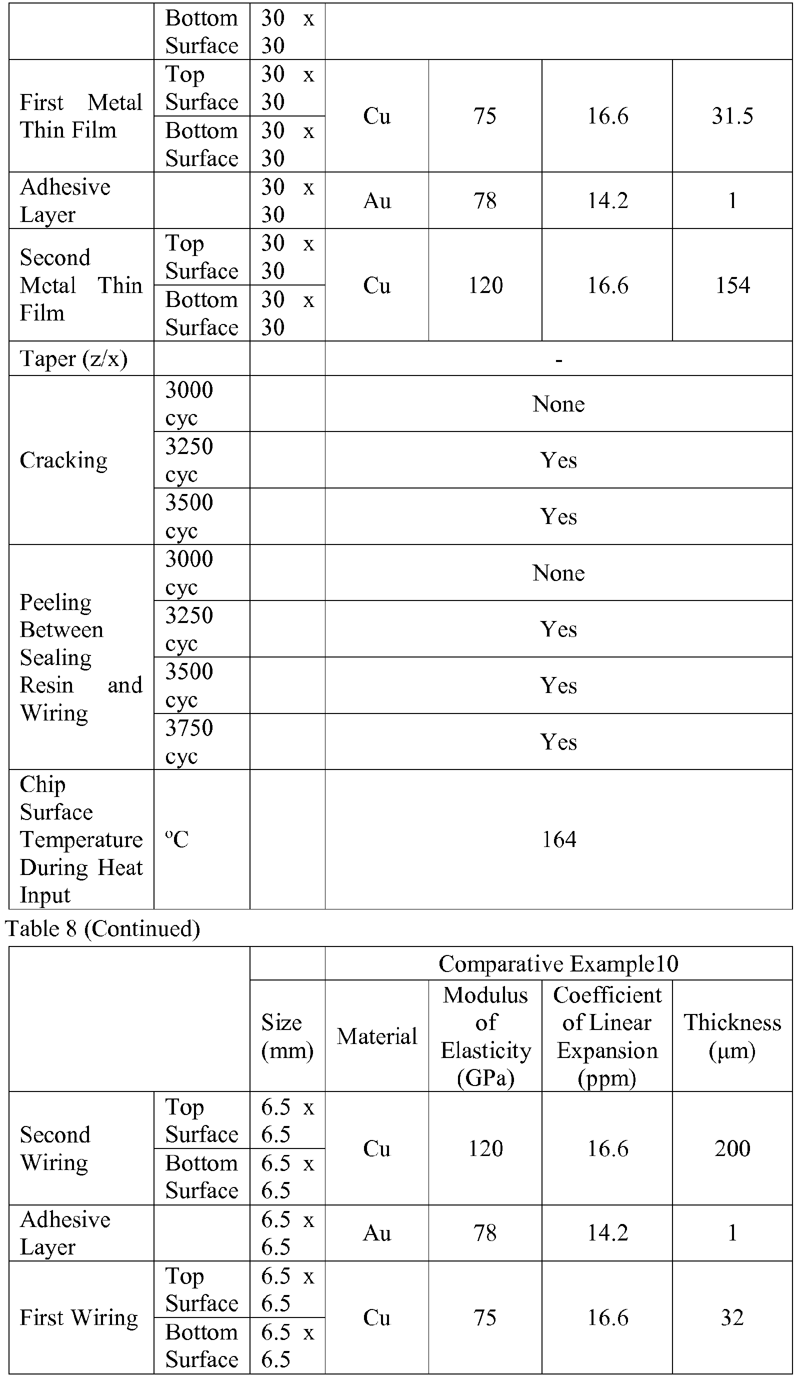

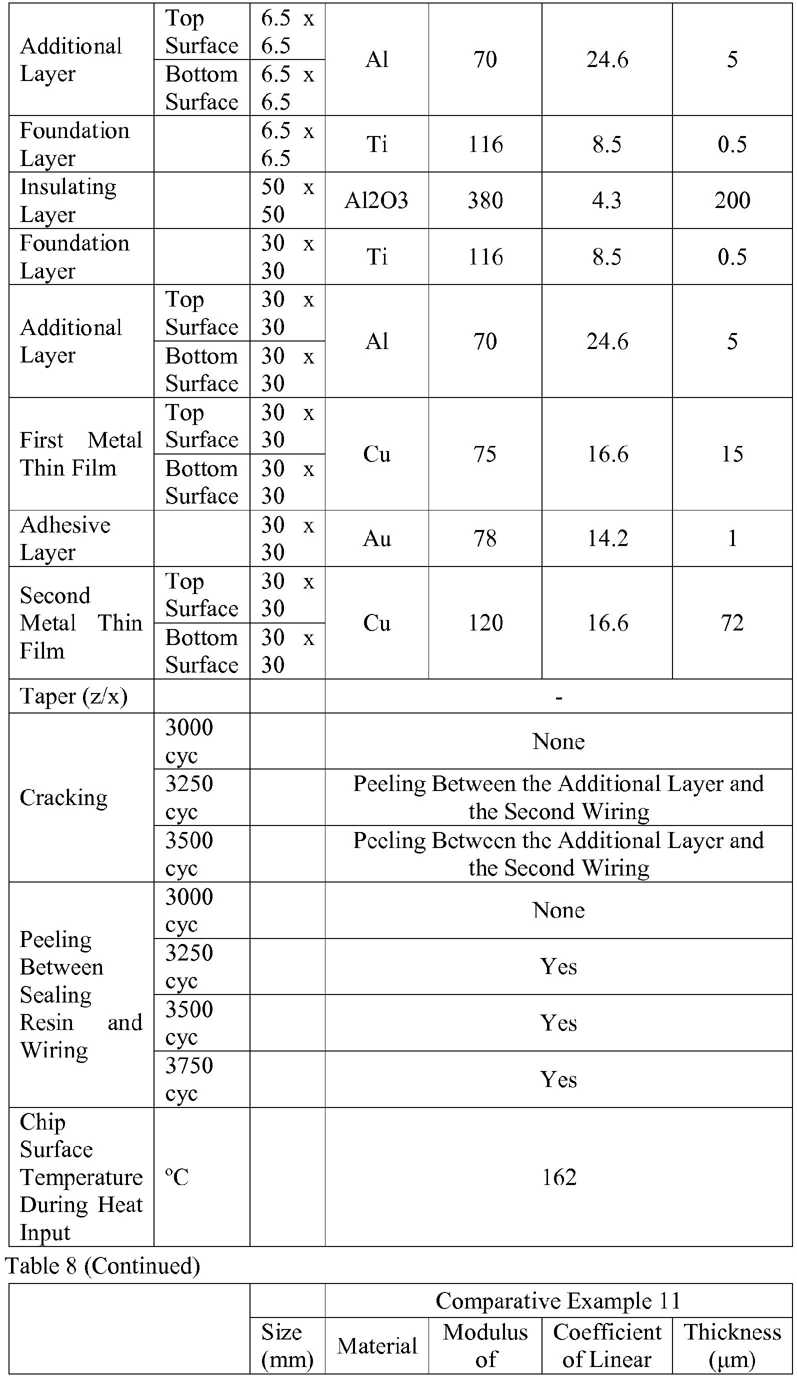

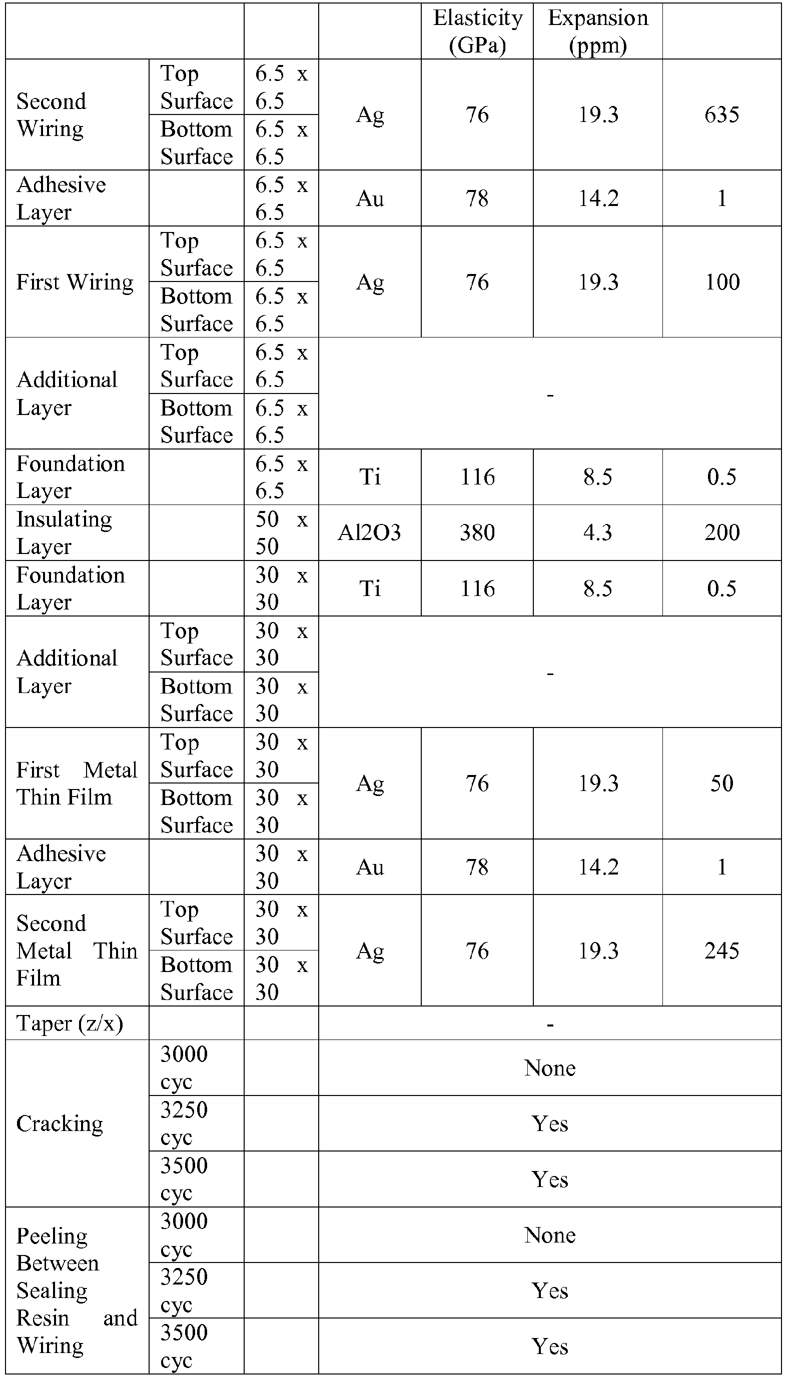

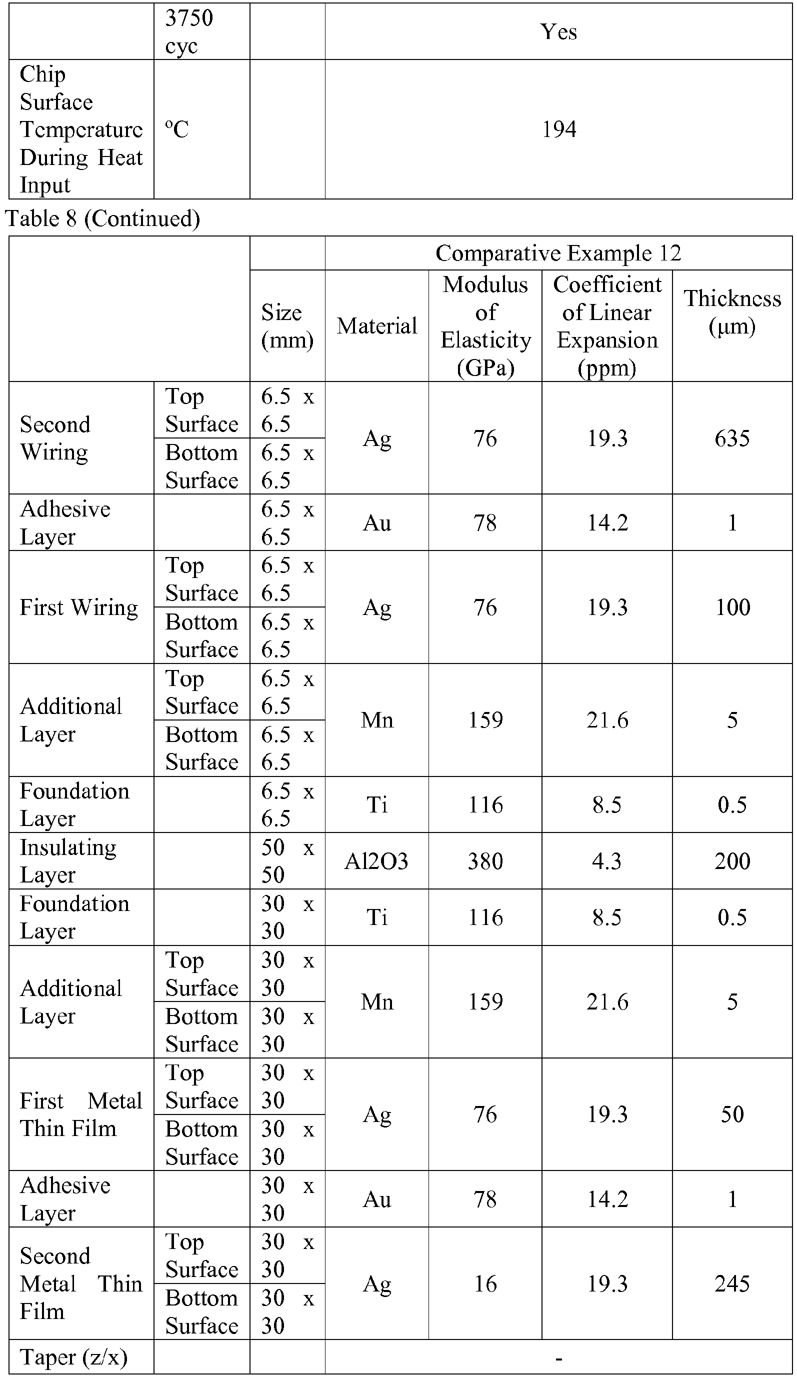

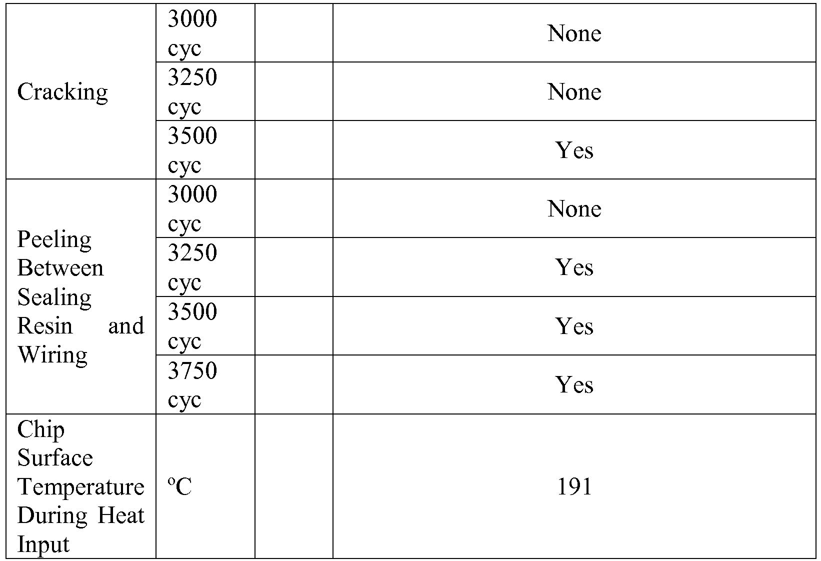

Because the surface areas of the surface of the substrate side and the surface opposite the surface of the substrate side of the layer provided on the substrate differ in working examples 8 to 25, peeling of the sealing resin and the wiring could be favorably suppressed, and heat dissipation was also favorable. Particularly, because z/x is less than or equal to 10 in working examples 8 to 10, 12, and 13 to 18, peeling of the sealing resin and the wiring did not occur even during the power cycle test of 3750 cycles. Further, because the additional layers with a higher modulus of elasticity than the porous conductive layer of the metal thin film are provided between the metal thin film and the substrate in working examples 8 to 16, 19 to 21, 24, and 25, cracks and delamination could be favorably suppressed. Particularly, because the thickness of the additional layers is 10 µm or less in working examples 8 to 14, 19, 24, and 25, cracks or delamination did not occur until at least 3250 cycles, and in working examples 8 to 13, where the coefficients of linear expansion of the additional layers are equal to or greater than the coefficient of linear expansion of the insulating layer, cracks or delamination did not occur until 3500 cycles.

In contrast, because the surface areas of the surface of the substrate side and the surface opposite the surface of the substrate side of the layer provided on the substrate are the same in comparative examples 3 to 12, peeling of the sealing resin and the wiring occurred and heat dissipation was unfavorable after exceeding 3000 cycles. As above, although cracks or delamination also occur more easily than in the working examples because peeling of the sealing resin and the wiring occurs easily, cracks or delamination was suppressed more than other comparative examples when providing additional layers with a higher modulus of elasticity than the porous conductive layer of the metal thin film at a thickness of 10 µm or less between the metal thin film and the substrate as in comparative examples 3, 6, 10, and 12.

As described above, according to the wiring substrate according to the present embodiment, because there is a plurality of vacancies inside the first wiring, even if the metal configuring the first wiring expands due to heat, the apparent modulus of elasticity decreases, because stress from thermal expansion is absorbed by the vacancies. Further, even if stress is caused by differences in the coefficients of linear expansion of the semiconductor element and the wiring (the second wiring in particular) and the substrate and the wiring (the second wiring in particular), stress is mitigated because it is absorbed by the vacancies. Therefore, delamination or cracks when the semiconductor element is mounted can be decreased. Further, the process time can be decreased and power consumption during the process can be reduced because there is no need for prolonged heating at a high temperature, such as when bonding the wiring composed solely of bulk material to the substrate, because the wiring includes the porous conductive layer having a plurality of vacancies inside.

Moreover, according to the wiring substrate according to the present embodiment, in addition to allowing the heat dissipation effect to be improved, adhesion with the sealing resin can be made favorable without increasing the thickness of the layers provided on the substrate and reliability can be improved, because the surface area of the side surface that connects to the surface of the substrate side and the surface opposite the surface of the substrate side increases due to a difference in surface area between the surface of the substrate side and the surface opposite the surface of the substrate side of the layers provided on the substrate. Further, cracks can be suppressed from occurring on the substrate by providing additional layers with a higher modulus of elasticity than that of the porous conductive layer, because heat expansion of the wiring is not transferred to the substrate. Particularly, cracking can be suppressed more effectively when the thickness of the additional layers are 10 µm or less, or moreover, 5 µm or less. Further, cracking can be suppressed more effectively even when the coefficients of linear expansion of the additional layers are equal to or greater than the coefficient of linear expansion of the insulating layer and the coefficient of linear expansion of the wiring.

## Claims

1. A wiring substrate comprising: a substrate having an insulating layer; and wiring provided on one surface side of the substrate;
the wiring comprising a porous conductive layer having a plurality of vacancies inside, and
the wiring having different surface areas for the surface of the substrate side and for the surface opposite the surface of the substrate side.

2. A wiring substrate comprising: a substrate having an insulating layer; and wiring provided on one surface side of the substrate;
the wiring comprising a porous conductive layer having a plurality of vacancies inside, and
having an additional layer with a higher modulus of elasticity than the porous conductive layer between the wiring and the substrate, and
surface areas being different for the surface of the substrate side of the additional layer and for the surface opposite the surface of the substrate side of the wiring.

3. A wiring substrate comprising: a substrate having an insulating layer; and
wiring comprising a plurality of layers provided on one surface side of the substrate;
any one layer of the wiring comprising a porous conductive layer having a plurality of vacancies inside, and
the wiring having different surface areas for the surface of the substrate side and for the surface opposite the surface of the substrate side.

4. A wiring substrate comprising: a substrate having an insulating layer; and
wiring comprising a plurality of layers provided on one surface side of the substrate;
any one layer of the wiring comprising a porous conductive layer having a plurality of vacancies inside, and
having an additional layer with a higher modulus of elasticity than the porous conductive layer between the wiring and the substrate, and
surface areas being different for the surface of the substrate side of the additional layer and for the surface opposite the surface of the substrate side of the wiring.

5. The wiring substrate according to any one of claims 1 to 4, wherein surface areas are different for a surface of the substrate side and for a surface opposite the surface of the substrate side in all layers provided on the wiring side on the substrate, and
z/x is less than or equal to 10, when z is defined as a total thickness of all layers provided on the wiring side on the substrate and x is defined as a protruding length in one direction of any one surface relative to the other surface of a surface of the substrate side and a surface opposite the surface of the substrate side.

6. The wiring substrate according to any one of claims 1 to 5, further comprising a metal thin film on the other surface side of the substrate.

7. The wiring substrate according to claim 6, wherein the metal thin film comprises a porous conductive layer having a plurality of vacancies inside.

8. The wiring substrate according to claim 6, wherein the metal thin film comprises a plurality of layers and any one layer comprises a porous conductive layer having a plurality of vacancies inside.

9. The wiring substrate according to claim 8, wherein the wiring and the metal thin film comprise three layers, and each layer other than an intermediate layer comprises a porous conductive layer having a plurality of vacancies inside.

10. The wiring substrate according to any one of claims 7 to 9, further comprising an additional layer having a higher modulus of elasticity than the porous conductive layer of the metal thin film, between the metal thin film and the substrate.

11. The wiring substrate according to any one of claims 6 to 10, wherein surface areas are different for a surface of the substrate side and for a surface opposite the surface of the substrate side in all layers provided on the metal thin film side on the substrate, and
z/x is less than or equal to 10, when z is defined as a total thickness of all layers provided on the wiring side on the substrate and x is defined as a protruding length in one direction of any one surface relative to the other surface of a surface of the substrate side and a surface opposite the surface of the substrate side.

12. The wiring substrate according to any one of claim 2 and claims 4 to 11, wherein a thickness of the additional layer is not more than 10 µm.

13. The wiring substrate according to any one of claim 2 and claims 4 to 12, wherein a coefficient of linear expansion of the additional layer is not less than a coefficient of linear expansion of the insulating layer and is not greater than a coefficient of linear expansion of the wiring.

14. The wiring substrate according to any one of claims 1 to 13, wherein the substrate has a foundation layer for adhering with other members.

15. The wiring substrate according to any one of claims 3, 4, and 9, further comprising an adhesive layer for adhering with other members, on one or both surfaces of a layer other than the porous conductive layer of the wiring.

16. The wiring substrate according to either claim 8 or 9, further comprising an adhesive layer for adhering with other members, on one or both surfaces of a layer other than the porous conductive layer of the metal thin film.

17. The wiring substrate according to any one of claims 1 to 16, wherein a processing layer processed to cause atomic vacancy and/or dislocation is formed on a top surface of at least any one layer provided on the insulating layer.

18. The wiring substrate according to any one of claims 3, 4, and 9, wherein a layer other than the porous conductive layer of the wiring comprises one type of metal, an alloy of two or more types of metals, or an alloy where a main component is made up of one or more types of metals, selected from a metal element group comprising Cu, Al, Au, and Ag.

19. The wiring substrate according to either claim 8 or 9, wherein a layer other than the porous conductive layer of the metal thin film comprises one type of metal, an alloy of two or more types of metals, or an alloy where a main component is made up of one or more types of metals, selected from a metal element group comprising Cu, Al, Au, and Ag.

20. The wiring substrate according to any one of claims 3, 4, and 9, wherein a layer other than the porous conductive layer of the wiring is softened by being annealed.

21. The wiring substrate according to either claim 8 or 9, wherein a layer other than the porous conductive layer of the wiring is softened by being annealed.

22. The wiring substrate according to claim 14, wherein the foundation layer comprises a metal material, an organic material, or a blended material of a metal material and an organic material.

23. The wiring substrate according to any one of claims 1 to 22, wherein the insulating layer comprises an organic material or ceramics.

24. The wiring substrate according to any one of claims 1 to 23, wherein the insulating layer comprises any one or plurality of Al₂O₃, AlN, Si₃N₄, and glass.

25. The wiring substrate according to any one of claims 1 to 24, wherein the porous conductive layer is made of sintered metallic fine particles.

26. The wiring substrate according to any one of claims 1 to 25, wherein the vacancies are filled with organic material at any ratio.

27. The wiring substrate according to any one of claims 1 to 26, wherein a volume percent for occupancy of a metal material within the porous conductive layer is in a range between 50 and 99.999%.

28. The wiring substrate according to claim 25, wherein the metallic fine particles comprise particles having an average particle diameter of primary particles of 1 nm to 500 nm at a ratio of 50 wt% or more and particles having an average particle diameter of primary particles of 0.5 µm to 50 µm at a ratio of 50 wt% or less.

29. The wiring substrate according to either claim 25 or 28, wherein the metallic fine particles are components of mainly metal of any one type or two or more types from among Cu, Ag, Au, Al, Ni, Sn, In, and Ti.

30. The wiring substrate according to any one of claims 1, 6, 11, and 13, wherein the insulating layer is Al₂O₃ or AlN, and a ratio of a thickness of the insulating layer to a thickness of a layer other than the porous conductive layer of the wiring is 1.5 or less.

31. The wiring substrate according to any one of claims 4, 9, 18, and 20 wherein the insulating layer is Si₃N₄, and a ratio of a thickness of the insulating layer to a thickness of a layer other than the porous conductive layer of the wiring is 0.25 or less.

32. A manufacturing method of a wiring substrate that manufactures a wiring substrate according to any one of claims 1 to 31, the manufacturing method of a wiring substrate comprising:
heating a material where a main component is metallic fine particles while applying pressure, and
bonding mutually between metallic fine particles and bonding the metallic fine particles to other layers to form the porous conductive layer.

33. A manufacturing method of a wiring substrate that manufactures a wiring substrate according to any one of claims 1 to 31, the manufacturing method of a wiring substrate comprising:
heating a material where a main component is metallic fine particles without applying pressure, and
bonding mutually between metallic fine particles and bonding the metallic fine particles to other layers to form the porous conductive layer.

34. A semiconductor device comprising semiconductor elements mounted on a wiring substrate according to any one of claims 1 to 31.

35. The semiconductor device according to claim 34, wherein the semiconductor elements are connected to the wiring substrate by an element connecting porous conductive layer having a plurality of vacancies inside.
